# EUROPÄISCHE PATENTSCHRIFT

(11) **EP 3 552 059 B1**
(45) Veröffentlichungstag und Bekanntmachung des Hinweises auf die Patenterteilung: **27.01.2021**
(21) Anmeldenummer: 16809762.4
(22) Anmeldetag: 07.12.2016
(51) Int. Cl.: G03F 7/20, B41J 3/407, B41J 11/00

(54) **VERFAHREN UND VORRICHTUNG ZUM STRUKTURIERTEN PASSIVIEREN EINES ENDLOSBANDES**
METHOD AND DEVICE FOR THE STRUCTURED PASSIVATION OF AN ENDLESS STRIP
PROCÉDÉ ET DISPOSITIF DE PASSIVATION STRUCTURÉE D'UNE BANDE SANS FIN

(43) Veröffentlichungstag der Anmeldung: 16.10.2019
(73) Patentinhaber: Berndorf Band GmbH, 2560 Berndorf (AT)
(72) Erfinder: BIACK, Michael, 1020 Wien (AT); FASST, Dominik, 2732 Würflach (AT)
(74) Vertreter: Burger, Hannes
(86) Internationale Anmeldenummer: PCT/EP2016/080128
(87) Internationale Veröffentlichungsnummer: WO 2017/046424

(56) Entgegenhaltungen:
- WO-A1-2007/147376
- WO-A1-2015/018760
- WO-A2-2015/054715

## Beschreibung

Die Erfindung betrifft ein Verfahren zum strukturierten Passivieren eines Endlosbandes, insbesondere eines metallischen Endlosbandes, bei dem das Endlosband zwischen zumindest zwei Umlenkrollen aufgespannt wird, von denen wenigstens eine angetrieben ist, und eine Maske auf das Endlosband zur strukturierten Passivierung desselben mit Hilfe eines Düsenkopfes/Druckkopfes im digitalen Strahldruckverfahren aufgetragen wird. Die aufgetragene Maske besteht aus einem mit Licht härtbarem Maskenmaterial oder enthält zumindest solche Bestandteile. Nach der Auftragung der Maske erfolgt in einem weiteren Schritt eine zumindest teilweise Bestrahlung der Maske mittels einer zur Härtung geeigneten Lichtquelle. Weiterhin betrifft die Erfindung eine Vorrichtung zur Durchführung des genannten Verfahrens. Die Vorrichtung umfasst demgemäß zumindest zwei Umlenkrollen, von denen wenigstens eine angetrieben ist und zwischen denen das Endlosband spannbar ist, einen Düsenkopf/Druckkopf, welcher zum Auftragen einer Maske auf das Endlosband im digitalen Strahldruckverfahren ausgebildet ist, und eine im Bereich einer Umlenkrolle oder zwischen den Umlenkrollen angeordnete Lichtquelle.

Ein Verfahren und eine Vorrichtung der genannten Art sind grundsätzlich bekannt. Beispielsweise offenbart die WO 2002/094580 A1 dazu ein Verfahren zum Strukturieren von endlosen Bändern, insbesondere Stahlbändern, wobei auf einer Außenfläche des Bandes eine Beschichtung aufgetragen wird. Die Beschichtung wird mit einzelnen Tropfen gebildet, die gegen die Außenfläche des Bandes gesprüht werden und auf dieser verbleiben. Es kann auch eine flächendeckende Beschichtung aufgebracht werden, welche durch Einwirkung von thermisch wirkenden Strahlen abgebaut und/oder abgetragen wird, vorzugsweise punktweise. Die so erhaltenen Endlosbänder können zum Beispiel in Pressen eingesetzt werden, vorzugsweise Doppelbandpressen.

Die WO 2007/147376 A1 offenbart weiterhin ein Verfahren zur Oberflächenstrukturierung eines Pressbleches oder eines Endlosbandes, wobei durch Auftragen einer Maske zur partiellen Passivierung eine Oberflächenstruktur vorgegeben und durch anschließende chemische Oberflächenbearbeitung hergestellt wird. Dabei wird das Pressblech oder Endlosband auf einem Arbeitstisch mit einer planen Oberfläche zum Auftragen und Aushärten einer Maske gelagert und eine aus aushärtbarem UV-Lack bestehenden Maske mittels eines digitalisierten Druckverfahrens zur partiellen Passivierung aufgetragen. Direkt nach der Auftragung erfolgt In einem weiteren Schritt eine Bestrahlung mit einer UV-Lichtquelle zum Aushärten der Maske.

Die WO 2014/015355 A1 offenbart ein weiteres Verfahren zum Strukturieren eines Pressbandes aus Metall, welches Oberflächenbereiche mit dreidimensionalen Prägestrukturen aufweist. Dabei wird auf eine Außenfläche des Pressbandes mittels eines digital gesteuerten Druckverfahrens eine Beschichtung aufgetragen. Die Prägestrukturen werden sodann durch Ab-/oder Auftragen von Material von unbeschichteten Bereichen des Pressbandes erzeugt. Die Länge und Breite der Prägestrukturen wird dabei unter Berücksichtigung einer zu erwartenden Dehnung des Pressbandes in einem Betriebszustand festgelegt.

Weiterhin offenbart die WO 2015/054715 A2 ein Verfahren zum Aufbringen einer maskenförmigen Beschichtung mittels eines digitalen Druckverfahrens auf ein Endlosband, wobei eine Maßverkörperung auf das Endlosband aufgebracht und mit Hilfe eines Sensors deren Position und/oder periodischen Teilung erfasst wird. Es wird dann ein Tropfen eines Beschichtungsmaterials auf das Endlosband aufgebracht, wenn die vom Sensor erfasste Position der Maßverkörperung einer Sollposition entspricht und/oder wenn der Sensor ein Ende oder einen Anfang einer Teilungsperiode der Maßverkörperung detektiert.

Die WO 2015/018760 A1 offenbart auch ein Verfahren zum Erzeugen einer strukturierten Maske auf einer zum Prägen zu verwendenden Oberfläche eines Endlospressbands oder einer Prägewalze, bei dem mit einem digitalen Drucker eine ätzresistente Beschichtung auf die Oberfläche aufgetragen wird. Um ein möglichst gleichförmiges Druckbild zu erzielen, wird die Beschichtung in mindestens einer wendelförmigen Bahn auf die Oberfläche aufgedruckt.

Die WO 2015/054715 A2 offenbart schließlich ein Verfahren zum Aufbringen einer maskenförmigen Beschichtung auf ein Endlosband, wobei die Beschichtung mittels eines Druckers in Tropfenform auf eines Außenfläche des Endlosbandes aufgetragen wird. Dabei wird eine Maßverkörperung auf das Endlosband aufgebracht oder übertragen, die Position der Maßverkörperung und/oder einer periodischen Teilung der Maßverkörperung erfasst und ein Signal zum Drucken erzeugt, wenn die erfasste Position der Maßverkörperung einer Sollposition entspricht und/oder wenn ein Ende oder ein Anfang einer Teilungsperiode der Maßverkörperung detektiert wird.

Insbesondere an der WO 2002/094580 A1 beziehungsweise an der WO 2007/147376 A1 ist nachteilig, dass diese nicht offenbaren, wo der Düsenkopf/Druckkopf und die Lichtquelle vorteilhafterweise für die Bearbeitung eines Endlosbands angeordnet sind, beziehungsweise sind die offenbarten Positionen dafür ungünstig oder ungeeignet. Des Weiteren werden im Stand der Technik jeweils nur Teilaspekte des strukturierten Passivierens eines Endlosbandes behandelt, und es fehlt an einer integrierten Lösung.

Eine Aufgabe der Erfindung ist es daher, ein verbessertes Verfahren und eine verbesserte Vorrichtung zum strukturierten Passivieren eines Endlosbandes anzugeben. Insbesondere sollen Positionen von Düsenkopf/Druckkopf und Lichtquelle angegeben werden, die für die Bearbeitung eines Endlosbands vorteilhaft sind. Im Speziellen soll das angegebene Verfahren und die angegebene Vorrichtung auch eine integrierte Lösung für das strukturierte Passivieren eines Endlosbandes bereitstellen.

Die Aufgabe der Erfindung wird mit einem Verfahren der eingangs genannten Art gelöst, bei dem das Auftragen der Maske auf das Endlosband, welches insbesondere aus Metall (z.B. Edelstahl) besteht, im Bereich einer Umlenkrolle erfolgt und vor dem Auftragen der Maske eine Positionsmarke und/oder eine an die Länge des Endlosbands angepasste Maßverkörperung auf das Endlosband aufgebracht wird, insbesondere im Randbereich des Endlosbands.

Dementsprechend wird die Aufgabe der Erfindung auch durch eine Vorrichtung der eingangs genannten Art gelöst, bei welcher der Düsenkopf/Druckkopf im Bereich einer Umlenkrolle angeordnet ist und ein Sensor zur Erfassung einer auf das Endlosband aufgebrachten Positionsmarke und/oder einer an die Länge des Endlosbands angepassten Maßverkörperung vorgesehen ist.

Das Endlosband läuft im Bereich einer Umlenkrolle vergleichsweise ruhig, und Schwingungen im Endlosband haben keinen oder nur geringen Einfluss auf die Lage des Endlosbands im Bereich der Umlenkrolle. Dadurch kann auch das Auftragen der Maske mit hoher Genauigkeit erfolgen. Ein weiterer Vorteil liegt auch darin begründet, dass durch die vorgegebene Lage des Endlosbands im Bereich der Umlenkrolle auch der Abstand zwischen dem Düsenkopf/Druckkopf und dem Endlosband praktisch unbeeinflusst von Schwingungen im Endlosband ist. Die vorgeschlagene Vorrichtung braucht daher im Grunde keine Einstellmöglichkeit zur Einstellung des Abstands zwischen Düsenkopf/Druckkopf und Endlosband aufzuweisen, sondern dieser kann konstruktiv fix vorgegeben sein. Nichts desto trotz kann eine Einstellmöglichkeit vorhanden sein, beispielsweise eine manuelle Einstellmöglichkeit oder eine motorische Einstellmöglichkeit (insbesondere eine motorische Einstellmöglichkeit, welche mit einer Abstandsregelung gekoppelt ist). Weiterhin wird auch eine Position für die Lichtquelle angegeben. Besonders vorteilhaft ist es, wenn die Lichtquelle ebenfalls im Bereich einer Umlenkrolle angeordnet ist, weil dann die oben für den Düsenkopf/Druckkopf präsentierten Vorteile gleichermaßen für die Lichtquelle gelten. Prinzipiell kann die Lichtquelle aber auch zwischen den Umlenkrollen angeordnet sein, da Abstandsschwankungen beim Härten des aufgetragenen Maskenmaterials wesentlich geringeren Einfluss auf das erzielte Endergebnis haben als beim Aufragen des Maskenmaterials. Ein Vorteil des vorgestellten Verfahren ist auch, dass der Auftrag der Maske kontinuierlich oder quasi kontinuierlich erfolgen kann und ein wiederholtes Aufspannen und Ausrichten des Metallbands auf einem Arbeitstisch entfällt.

Das Maskenmaterial kann beispielsweise mit ultraviolettem Licht härtbar beziehungsweise vernetzbar sein, wobei die Lichtquelle zur Härtung/Vernetzung des Maskenmaterials ultraviolettes Licht ausstrahlt. Denkbar ist aber auch, dass das Maskenmaterial mit infrarotem Licht härtbar/vernetzbar ist und die Lichtquelle demzufolge infrarotes Licht ausstrahlt. Insbesondere wird die vollständige, mit Maskenmaterial bedeckte Oberfläche des Endlosbands, mit Licht bestrahlt, wenngleich auch die Bestrahlung nach und nach durch Bestrahlung von Teilarealen erfolgt.

Der Düsenkopf/Druckkopf kann mehrere entlang einer Linie, insbesondere entlang einer Geraden, angeordnete und in einem Düsenabstand voneinander beabstandete Düsen aufweisen, die einzeln angesteuert werden. Die Düsen können aber auch in Form einer Matrix angeordnet sein. Insbesondere kann der Düsenabstand in beiden Fällen 25 µm betragen.

Eine Maßverkörperung ist zum Beispiel ein Maßstab, der bestimmte einzelne Werte einer Messgröße oder einer Abfolge von Werten einer Messgröße darstellt. Im Rahmen der Erfindung wird beispielsweise ein Längenmaßstab auf das Endlosband aufgebracht. Die Teilung kann dabei metrisch sein oder nach dem Zoll-System erfolgen, kann aber auch in einer für das Endlosband spezifischen Einheit erfolgen. Die Maßverkörperung wird vor dem Auftragen der Maske auf das Endlosband aufgebracht und dient dazu, temporäre Längenänderungen des Endlosbands während dem Auftragen der Maske erkennen und ausgleichen zu können. Solche Längenänderungen können vom Antrieb der Umlenkrolle herrühren. Beispielsweise können Getriebespiel und/oder von einer Antriebsregelung herrührende Drehmomentstöße Schwingungen in das Metallband induzieren, die in Folge zu einer Abweichung der aufgetragenen Ist-Maske von einer gewünschten Soll-Maske führen können. Ein weiterer Grund für eine Abweichung der Ist-Maske von der gewünschten Soll-Maske kann auch darin begründet sein, dass das Endlosband auf der angetriebenen Umlenkrolle durchrutscht. Mit Hilfe der Maßverkörperung und eines (optischen) Sensors zur Erfassung der Maßverkörperung können die genannten Längenänderungen erkannt werden, und der Düsenkopf/Druckkopf kann dementsprechend geringfügig in x- und/oder y-Richtung verschoben werden. Die Maßverkörperung kann insbesondere an die Länge des Endlosbands angepasst sein, sodass diese endlos beziehungsweise nahtlos ist. Anstelle der Maßverkörperung oder zusätzlich dazu kann auch eine einzelne Positionsmarke zur Kennzeichnung einer eindeutigen Position auf dem Endlosband angebracht werden. Die Maßverkörperung/Positionsmarke kann beispielsweise aus dem Maskenmaterial bestehen, kann aber auch mit einer anderen Technologie auf das Endlosband aufgebracht werden, beispielsweise durch Lasergravur oder durch Aufbringen (z. B. Aufkleben) eines optischen oder magnetischen Maßbands.

Das Verfahren umfasst insbesondere die Schritte:
- Aufspannen des Endlosbandes zwischen zumindest zwei Umlenkrollen, von denen wenigstens eine angetrieben ist;
- Aufbringen und/oder Übertragen zumindest einer Maßverkörperung auf das Endlosband, insbesondere auf eine Oberfläche des Endlosbandes;
- Erfassen der Position der Maßverkörperung und/oder einer periodischen Teilung der Maßverkörperung mittels zumindest eines Sensors;
- Erzeugen eines Signals zum Auftragen der Maske und Übermittlung an den Düsenkopf/Druckkopf, wenn die von dem zumindest einen Sensor erfasste Position der Maßverkörperung auf der Oberfläche des Endlosbandes einer Sollposition entspricht und/oder wenn der zumindest eine Sensor ein Ende oder einen Anfang einer Teilungsperiode der Maßverkörperung detektiert und
- Ausstoßen von Tropfen des Maskenmaterials auf die Außenfläche des Endlosbandes mittels des Düsenkopfes/Druckkopfes nach Erhalt des Signals.

Weitere vorteilhafte Ausgestaltungen und Weiterbildungen der Erfindung ergeben sich aus den Unteransprüchen sowie aus der Beschreibung in Zusammenschau mit den Figuren.

Bei einer günstigen Ausführungsvariante des vorgeschlagenen Verfahrens wird das Endlosband während des Auftragens der Maske mit Hilfe der zumindest einen angetriebenen Umlenkrolle in einer x-Richtung bewegt, und der Düsenkopf/Druckkopf wird quer dazu, insbesondere rechtwinkelig dazu, in einer y-Richtung bewegt. Der Düsenkopf/Druckkopf braucht also im Grunde nur in einer Dimension bewegt zu werden, wodurch der Aufbau einer Mechanik zur Bewegung des Düsenkopfes/Druckkopfes vereinfacht wird. Prinzipiell kann aber auch der Düsenkopf/Druckkopf in einer x-Richtung bewegt werden, insbesondere über eine Strecke, die kürzer als das Endlosband lange ist.

Ebenso ist es günstig, wenn das Endlosband während der Bestrahlung der Maske mit Hilfe der zumindest einen angetriebenen Umlenkrolle in einer x-Richtung bewegt wird und die Lichtquelle quer dazu, insbesondere rechtwinkelig dazu, in einer y-Richtung bewegt wird. Die Lichtquelle braucht also im Grunde ebenfalls nur in einer Dimension bewegt zu werden, wodurch der Aufbau einer Mechanik zur Bewegung der Lichtquelle ebenfalls vereinfacht wird. Prinzipiell kann aber auch die Lichtquelle in einer x-Richtung bewegt werden, insbesondere über eine Strecke, die kürzer als das Endlosband lange ist.

Günstig ist es auch, wenn das Auftragen der Maske und die Bestrahlung der Maske gleichzeitig erfolgt. Dadurch kann die Passivierung des Endlosbands vergleichsweise rasch erfolgen.

In einer weiteren vorteilhaften Variante des vorgeschlagenen Verfahrens erfolgt das Auftragen der Maske und die Bestrahlung der Maske an unterschiedlichen Orten, insbesondere an derselben x-Position aber an unterschiedlichen y-Positionen oder an unterschiedlichen x-Positionen aber an derselben y-Position oder an unterschiedlichen x-Positionen und unterschiedlichen y-Positionen. Der Düsenkopf/Druckkopf und die Lichtquelle können somit im Hinblick auf die x-Position und/oder y-Position versetzt bewegt werden. Dadurch wird vermieden, dass ein von der Lichtquelle ausgehender Lichtstrahl über das Endlosband in den Düsenkopf/Druckkopf zurück reflektiert wird und dort das in den Düsen befindliche Maskenmaterial härtet und damit die Düsen verstopft.

Generell kann die Steuerung des Düsenkopfes/Druckkopfes und/oder der Lichtquelle beispielsweise über eine Speicherprogrammierbare Steuerung (SPS-Steuerung) erfolgen, wobei sowohl Bewegungsparameter (Geschwindigkeit, Position, Schrittweite, usw. des Düsenkopfes/Druckkopfes und/oder der Lichtquelle), Druckparameter (Menge des ausgestoßenen Materials, Druckfrequenz, usw. des Düsenkopfes/Druckkopfes) und/oder Belichtungsparameter (Leuchtintensität, Puls-Pausen-Verhältnis, usw. der Lichtquelle) steuerbar sein können.

Günstig ist es weiterhin, wenn die Maske in Zeilen aufgetragen wird, die in x-Richtung verlaufen. Das heißt, es werden in Längsrichtung beziehungsweise Bewegungsrichtung des Endlosbands verlaufende Zeilen auf das Band aufgetragen. Vorteilhaft kann der Düsenkopf/Druckkopf daher vergleichsweise lange an einer Stelle verharren und braucht nur selten weiterbewegt werden.

Günstig ist es aber auch, wenn die Maske in Zeilen aufgetragen wird, die in y-Richtung verlaufen. Das heißt, es werden in Querrichtung beziehungsweise quer zur Bewegungsrichtung des Endlosbands verlaufende Zeilen auf das Band aufgetragen. Vorteilhaft kann das Endlosband daher vergleichsweise lange an einer Stelle verharren und braucht nur selten weiterbewegt werden.

In einer weiteren günstigen Variante des vorgeschlagenen Verfahrens werden die Zeilen ohne Überlappung nebeneinander aufgetragen werden. Ein Zeilenvorschub beträgt dann insbesondere ein ganzzahliges Vielfaches des Düsenabstands. Dadurch kann die Maske vergleichsweise rasch auf das Metallband aufgetragen werden.

Besonders vorteilhaft ist es aber auch, wenn die Zeilen einander überlappend aufgetragen werden. Ein Zeilenvorschub beträgt dann insbesondere ein nicht ganzzahliges Vielfaches des Düsenabstands. Dadurch können dichter aneinander liegende Maskenpunkte auf das Endlosband aufgetragen werden, wodurch einerseits Lücken in der Maske gut vermieden werden können, wodurch andererseits aber auch die Auflösung beim Auftragen gesteigert werden kann und feinere Strukturen auf das Endlosband aufgetragen werden können als dies der nativen Auflösung des Düsenkopfes/Druckkopfes, also dem Düsenabstand, entsprechen würde. Beispielsweise kann ein Zeilenvorschub ein Drittel einer Zeilenhöhe betragen. Selbstverständlich sind aber auch andere Werte möglich, beispielsweise 1/2, 1/4, usw.

Vorteilhaft ist es in obigem Zusammenhang auch, wenn eine Druckfrequenz respektive Ausstoßfrequenz auf den Reziprokwert des Zeilenvorschubs gesteigert wird. Beträgt der Zeilenvorschub beispielsweise 1/3, dann wird die Druckfrequenz/Ausstoßfrequenz auf den gegenüber dem nicht-überlappenden Auftrag der Zeilen auf das Dreifache gesteigert. Werden nicht-überlappende Zeilen beispielsweise mit einer Druckfrequenz/Ausstoßfrequenz von 5 kHz aufgetragen, dann erfolgt der Auftrag bei einem Zeilenvorschub von 1/3 vorteilhaft bei einer Druckfrequenz/Ausstoßfrequenz von 15 kHz. Auf diese Weise bleibt die Auftragsgeschwindigkeit und damit die Zeit, welche vom Auftrag des Maskenmaterials bis zu dessen Härtung vergeht, gleich.

Besonders vorteilhaft ist es weiterhin, wenn
- die Ist-Länge und/oder Ist-Breite des Endlosbands bestimmt wird und
- eine Vielzahl von einzelnen identen Strukturen aneinandergereiht auf das Endlosband aufgetragen werden, wobei die Ist-Länge und/oder Ist-Breite des Endlosbands durch eine Soll-Länge und/oder Soll-Breite der einzelnen Strukturen dividiert und anschließend die Ist-Länge und/oder Ist-Breite der einzelnen Strukturen auf einen ganzzahligen Bruchteil der Ist-Länge und/oder Ist-Breite des Endlosbands angepasst wird das heißt proportional verändert wird.

Es kann vorkommen, dass die Soll-Strukturen zu kurz und/oder zu schmal sind um das Endlosband nahtlos zu bedecken. Dementsprechend werden die Soll-Strukturen so hinsichtlich ihrer Länge und/oder Breite angepasst, das heißt verlängert/verkürzt oder verbreitert/geschmälert, dass die Ist-Strukturen das Endlosband nahtlos bedecken.

In einer weiteren vorteilhaften Variante des vorgeschlagenen Verfahrens erfolgt das Auftragen der Maske unter Berücksichtigung einer zu erwartenden Dehnung des Endlosbands in einem Betriebszustand. Das Endlosband wird ja später beispielsweise in einer Bandgießanlage oder in einer Doppelbandpresse eingesetzt, in der das Endlosband zum Teil unter vergleichsweise hohe Zugspannungen gesetzt wird und sich dementsprechend dehnt. Damit einhergehend ist auch eine Dehnung der auf das Endlosband aufgebrachten Struktur, welche unter Umständen unerwünscht ist. Dementsprechend kann der spätere, zu erwartende Betriebszustand beim Auftragen der Maske auf das Endlosband berücksichtigt werden.

Besonders vorteilhaft ist es in diesem Zusammenhang, wenn das Auftragen der Maske bei der im Wesentlichen gleichen Zugbeanspruchung des Endlosbands erfolgt wie die zu erwartende spätere Zugebeanspruchung im späteren Betrieb des Endlosbands. Das heißt die Zugbeanspruchung und damit die Dehnung des Endlosbands sind beim Auftragen der Maske und im späteren Betrieb in etwa gleich, wodurch die Maske in der Form auf das Endlosband aufgetragen werden kann, in der sie auch im späteren Betrieb erscheinen soll.

Besonders vorteilhaft ist es aber auch, wenn das Auftragen der Maske bei einer anderen Zugbeanspruchung des Endlosbands erfolgt als die zu erwartende spätere Zugebeanspruchung im späteren Betrieb des Endlosbands, und unterschiedliche Dehnungen des Endlosbands in den beiden Zuständen beim Auftragen der Maske berücksichtigt werden. Dementsprechend wird die Maske beim Auftragen etwas in die Länge gezogen, wenn die Zugspannung und damit die Dehnung des Endlosbands beim Auftragen der Maske größer ist als im späteren Betrieb, oder die Maske wird beim Auftragen etwas verkürzt, wenn die Zugspannung und damit die Dehnung des Endlosbands beim Auftragen der Maske kleiner ist als im späteren Betrieb. Günstig ist es in diesem Zusammenhang, wenn die Dehnung des Pressbandes anhand eines Querschnitts des Endlosbands berechnet wird.

Günstig ist es zudem, wenn das Maskenmaterial aus einem organischen Monomer besteht, insbesondere aus einem Wachs mit Pigmenten und UV-härtenden Bestandteilen. Dieses Material kann einerseits gut im Strahldruckverfahren auf das Endlosband aufgebracht werden, weist aber auch eine gute Haltbarkeit bei einer eventuell nachfolgenden Behandlung des Endlosbands auf.

Günstig ist es darüber hinaus, wenn die Oberfläche des Endlosbands nach dem Auftragen und Härten der Maske chemisch bearbeitet, insbesondere mit Eisen(III)-chlorid geätzt, und danach die Maske entfernt wird. Dadurch kann eine dreidimensionale Struktur in der Oberfläche des Endlosbands hergestellt werden. Insbesondere können das strukturierte Passivieren und das anschließende chemische Bearbeiten rekursiv wiederholt und in mehreren Durchgängen aus geführt werden, wodurch auch komplexere dreidimensionale Strukturen herstellbar sind. Die Masken können sich in den unterschiedlichen Durchgängen voneinander unterscheiden.

In einer weiteren vorteilhaften Variante des vorgeschlagenen Verfahrens beträgt eine Umlaufgeschwindigkeit des Endlosbandes zwischen 10 und 20 m/min, insbesondere im Wesentlichen 15 m/min. Diese Werte haben sich bei Versuchen als besonders geeignet für die vorgeschlagene Vorrichtung herausgestellt.

Günstig ist es weiterhin, wenn die Lichtquelle kontinuierlich leuchtet oder diskontinuierlich Licht aussendet, insbesondere gepulst oder in Form von Lichtblitzen. Dadurch ist die Härtung des Maskenmaterials gut einstellbar, und es können auch unterschiedliche Maskenmaterialien gehärtet werden.

Besonders vorteilhaft ist es zudem, wenn wenigstens 90% des von der Lichtquelle ausgestrahlten Lichts vom Endlosband absorbiert werden. Dadurch wird das von der Lichtquelle ausgestrahlte Licht optimal ausgenutzt.

Vorteilhaft ist es auch, wenn sich die Farbe und/oder Transparenz der aufgetragenen Maske bei Bestrahlung mit der Lichtquelle ändert. Die Farbe der Maske kann beispielsweise dunkler werden, wodurch sich die Sichtbarkeit und die Beurteilbarkeit des Auftrags durch einen Betrachter verbessert.

Besonders vorteilhaft ist es zudem, wenn eine Wellenlänge des Strahlungsmaximums im emittierten Spektrum der Lichtquelle auf eine Wellenlänge der maximalen spektralen Absorption des Endlosbands abgestimmt ist. Dadurch wird das von der Lichtquelle ausgestrahlte Licht optimal ausgenutzt.

Besonders vorteilhaft ist es, wenn der Düsenkopf/Druckkopf im Bereich des Scheitelpunkts der Umlenkrolle angeordnet ist und eine Strahlrichtung des Düsenkopfes/Druckkopfes in einem Bereich von +/- 10° um eine horizontale Richtung ausgerichtet ist. Vorteilhaft braucht der Düsenkopf/Druckkopf bei Revisionsarbeiten nicht von der Umlenkrolle weggehoben werden, sondern muss nur horizontal verschoben werden. Des Weiteren kann ein tropfender Düsenkopf/Druckkopf nicht das Endlosband verschmutzen und unter Umständen unbrauchbar machen. Schließlich liegt das Endlosband an dieser Stelle der Umlenkrolle aufgrund der wirkenden Kräfte auch besonders gut auf dieser auf. Der Abstand zwischen dem Endlosband und dem Düsenkopf/Druckkopf ist daher besonders gut definiert. Trotz aller Vorteile dieser Anordnung kann der Düsenkopf/Druckkopf auch anders angeordnet sein. Beispielsweise kann er im Wesentlichen 45° gegen die Vertikale geneigt und nach unten ausgerichtet sein, oder kann in einem Bereich von +/- 10° um eine vertikale Richtung ausgerichtet sein, insbesondere nach unten.

Besonders vorteilhaft ist es ebenfalls, wenn die Lichtquelle im Bereich der Umlenkrolle angeordnet ist und eine mittlere Leuchtrichtung in einem Bereich von +/- 10° um eine vertikale Richtung ausgerichtet ist, insbesondere nach oben. Bei dieser Anordnung liegt ein eventueller Lichtaustritt aus der Vorrichtung relativ tief und in der Regel weit unter der Augenhöhe, sodass eine Augenschädigung durch austretendes Licht unwahrscheinlich ist und die Arbeitssicherheit verbessert wird. Nichts desto trotz kann die Lichtquelle aber auch anders angeordnet sein. Beispielsweise kann sie nach unten leuchten oder auch horizontal oder um 45° gegenüber einer Horizontalen geneigt ausgerichtet sein.

In einer weiteren günstigen Ausführungsvariante der vorgeschlagenen Vorrichtung beträgt der Abstand vom Düsenkopf/Druckkopf zum Endlosband zwischen 1 und 5 mm und der Abstand von der Lichtquelle zum Endlosband zwischen 10 und 100 mm. Diese Werte haben sich bei Versuchen als besonders geeignet für die vorgeschlagene Vorrichtung herausgestellt.

Besonders vorteilhaft ist es weiterhin, wenn kein von der Lichtquelle ausgehender Lichtstrahl direkt oder nach einfacher Reflexion am Endlosband in eine Düse des Düsenkopfs/Drucckopfs führt. Dadurch wird vermieden, dass ein von der Lichtquelle ausgehender Lichtstrahl über das Endlosband in den Düsenkopf/Druckkopf zurück reflektiert wird und dort das in den Düsen befindliche Maskenmaterial härtet und damit die Düsen verstopft.

Besonders vorteilhaft ist es darüber hinaus, wenn jeder von der Lichtquelle ausgehende Lichtstrahl auf das Endlosband trifft und insbesondere zur Gänze durch die Oberfläche des Endlosbands absorbiert wird. Dadurch wird ebenfalls vermieden, dass ein von der Lichtquelle ausgehender Lichtstrahl über das Endlosband in den Düsenkopf/Druckkopf zurück reflektiert wird und dort das in den Düsen befindliche Maskenmaterial härtet und damit die Düsen verstopft. Zudem wird das von der Lichtquelle ausgestrahlte Licht optimal ausgenutzt. Bei vollständiger oder nahezu vollständiger Absorption des Lichts durch das Endlosband wird auch vermieden, dass dieses aus der Vorrichtung austritt und beispielsweise im Bereich der Vorrichtung anwesende Personen beeinträchtigt oder gar gesundheitlich schädigt. Somit wird auch die Arbeitssicherheit verbessert.

In einer weiteren besonders vorteilhaften Ausführungsvariante der vorgeschlagenen Vorrichtung schließt eine mittlere Strahlrichtung des Düsenkopfes/Druckkopfes und eine mittlere Strahlrichtung der Lichtquelle einen Winkel von zumindest 45° ein. Weitere bevorzugte Werte sind zumindest 90°, zumindest 135° und im Wesentlichen 180°, das heißt zumindest 170°. Dadurch wird ebenfalls vermieden, dass ein von der Lichtquelle ausgehender Lichtstrahl über das Endlosband in den Düsenkopf/Druckkopf zurück reflektiert wird und dort das in den Düsen befindliche Maskenmaterial härtet und damit die Düsen verstopft.

Vorteilhaft ist es auch, wenn ein Strahlungsmaximum der Lichtquelle im emittierten Spektrum auf eine Wellenlänge in einem Bereich um die maximale Absorption durch das Endlosband abgestimmt ist. Dadurch wird das von der Lichtquelle ausgestrahlte Licht optimal ausgenutzt.

Günstig ist es zudem, wenn eine Ausdruckfrequenz des Düsenkopfs/Druckkopfs zwischen 5 kHz und 40 kHz beträgt, insbesondere im Wesentlichen 10 kHz. Diese Werte haben sich bei Versuchen als besonders geeignet für die vorgeschlagene Vorrichtung herausgestellt.

Günstig ist es, wenn die Lichtquelle als Leuchtdiode, Quecksilberdampflampe, Xenonlampe, Laserdiode oder als Laser ausgebildet ist. Diese Lichtquellen sind erprobte und vergleichsweise leicht verfügbare Mittel. Die vorgeschlagene Vorrichtung kann daher mit relativ geringem technischen Aufwand in die Realität umgesetzt werden und ist darüber hinaus auch zuverlässig.

Vorteilhaft ist es auch, wenn der Düsenkopf/Druckkopf im Bereich einer ersten Umlenkrolle und die Lichtquelle im Bereich einer von der ersten Umlenkrolle beabstandeten zweiten Umlenkrolle angeordnet sind. Dadurch wird ebenfalls vermieden, dass ein von der Lichtquelle ausgehender Lichtstrahl über das Endlosband in den Düsenkopf/Druckkopf zurück reflektiert wird und dort das in den Düsen befindliche Maskenmaterial härtet und damit die Düsen verstopft, da die Umlenkrollen zumeist relativ weit voneinander beabstandet angeordnet sind.

Vorteilhaft ist es schließlich auch, wenn der Düsenkopf/Druckkopf und die Lichtquelle im Bereich derselben Umlenkrolle angeordnet sind. Auf diese Weise kann die Maske rasch nach dem Auftragen bestrahlt und damit gehärtet werden, da der Abstand zwischen dem Düsenkopf/Druckkopf und der Lichtquelle vergleichsweise gering sind.

An dieser Stelle wird auch festgehalten, dass sich die zu der vorgestellten Vorrichtungen präsentierten Ausführungsvarianten und die daraus resultierenden Vorteile sinngemäß auch für das offenbarte Verfahren beziehen und umgekehrt.

Zum besseren Verständnis der Erfindung wird diese anhand der nachfolgenden Figuren näher erläutert. Es zeigen:
- Fig. 1: ein erstes Beispiel einer schematisch dargestellten Vorrichtung zum strukturierten Passivieren eines Endlosbandes, bei welcher der Düsenkopf/Druckkopf und die Lichtquelle im Bereich unterschiedlicher Umlenkrollen angeordnet sind, in Seitenansicht;
- Fig. 2: ein zweites Beispiel einer Vorrichtung zum strukturierten Passivieren eines Endlosbandes, bei welcher der Düsenkopf/Druckkopf und die Lichtquelle im Bereich von mittig angeordneten Umlenkrollen vorgesehen sind;
- Fig. 3: ein weiteres Beispiel einer Vorrichtung zum strukturierten Passivieren eines Endlosbandes, bei welcher der Düsenkopf/Druckkopf und die Lichtquelle im Bereich derselben Umlenkrollen angeordnet sind;
- Fig. 4: die Vorrichtung aus Fig. 3 in Unteransicht;
- Fig. 5: ein Beispiel für den Aufbau der Maske unter Verwendung zueinander versetzter Zeilen;
- Fig. 6: ein Beispiel für einen Düsenkopf/Druckkopf mit matrixförmig angeordneten Düsen;
- Fig. 7: einen detaillierten Ausschnitt aus der in den Figuren 3 und 4 dargestellten Vorrichtung, welche die Abschattung der Lichtquelle durch die Umlenkrolle zeigt;
- Fig. 8: ein Beispiel für ein Endlosband mit einer Maßverkörperung und
- Fig. 9: ein Beispiel für ein Endlosband mit aneinander gereihten und sich wiederholenden Maskenstrukturen.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und bei einer Lageänderung sinngemäß auf die neue Lage zu übertragen. Weiterhin können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

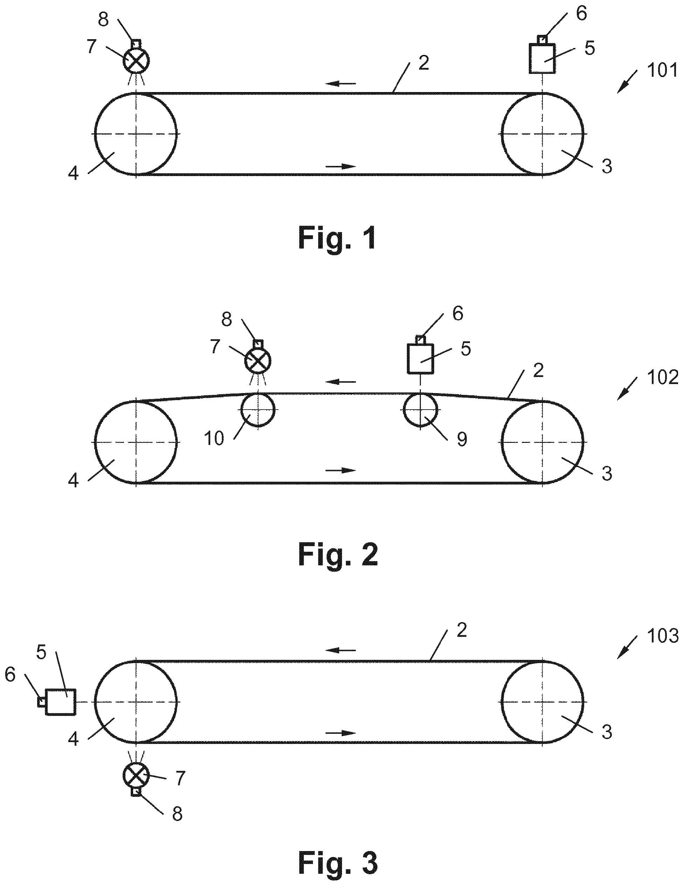

Fig. 1 zeigt eine schematisch dargestellte Vorrichtung 101 zum strukturierten Passivieren eines Endlosbandes 2 in Seitenansicht. Die Vorrichtung 101umfasst eine erste Umlenkrolle 3 und eine zweite Umlenkrolle 4, von denen wenigstens eine angetrieben ist und zwischen denen das Endlosband 2 gespannt ist. Im konkreten Beispiel wird angenommen, dass die erste Umlenkrolle 3 motorisch angetrieben ist. Es könnte aber auch die zweite Umlenkrolle 4 angetrieben sein oder beide Umlenkrollen 3, 4.

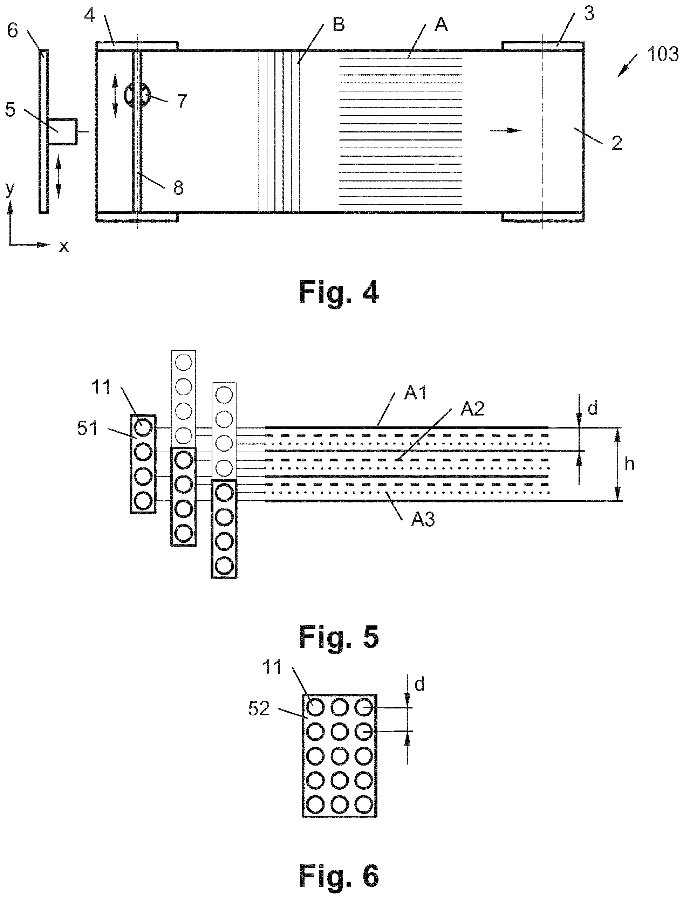

Zudem umfasst die Vorrichtung 101 einen Düsenkopf/Druckkopf 5, welcher zum Auftragen einer Maske auf das Endlosband 2 im digitalen Strahldruckverfahren ausgebildet ist und welcher im Bereich der ersten Umlenkrolle 3 angeordnet ist. Der Düsenkopf/Druckkopf 5 ist in diesem Beispiel entlang einer ersten, quer zur Bewegungsrichtung des Endlosbands 2 verlaufenden, Schiene 6 verfahrbar (vergleiche dazu auch Fig. 4). Schließlich umfasst die Vorrichtung 101 auch eine Lichtquelle 7, welche zur Härtung der aufgetragenen Maske durch Bestrahlung mit Licht ausgebildet ist und welche in diesem Beispiel im Bereich der zweiten Umlenkrolle 4 angeordnet ist. Die Lichtquelle 7 ist in diesem Beispiel entlang einer zweiten, quer zur Bewegungsrichtung des Endlosbands 2 verlaufenden, Schiene 8 verfahrbar (vergleiche dazu auch Fig. 4).

Fig. 2 zeigt eine weitere Vorrichtung 102 zum strukturierten Passivieren des Endlosbandes 2, welche der in Fig. 1 dargestellten Vorrichtung 101 sehr ähnlich ist. Im Unterschied dazu ist das Endlosband 2 aber über zwei weitere Umlenkrollen 9 und 10 geführt, wobei der Umschlingungswinkel deutlich geringer ist als der Umschlingungswinkel an den Umlenkrollen 3 und 4. Der Düsenkopf/Druckkopf 5 ist im Bereich der dritten Umlenkrolle 9 und die Lichtquelle 7 im Bereich der von der dritten Umlenkrolle 9 beabstandeten vierten Umlenkrolle 10 angeordnet.

Fig. 3 zeigt noch ein weiteres Beispiel einer Vorrichtung 103 zum strukturierten Passivieren des Endlosbandes 2, welche den in den Figuren 1 und 2 dargestellten Vorrichtungen 101, 102 ähnlich ist. Im Unterschied dazu sind der Düsenkopf/Druckkopf 5 und die Lichtquelle 7 nun im Bereich einer einzigen, hier im Bereich der zweiten, Umlenkrolle 4 angeordnet. Konkret ist der Düsenkopf/Druckkopf 5 im Bereich des Scheitelpunkts der zweiten Umlenkrolle 4 angeordnet, und eine Strahlrichtung des Düsenkopfes/Druckkopfes 5 ist in horizontaler Richtung ausgerichtet. Eine mittlere Leuchtrichtung der Lichtquelle 7 ist in eine vertikale Richtung ausgerichtet, hier nach oben.

Fig. 4 zeigt eine schematische Ansicht der in Fig. 3 dargestellten Vorrichtung 103 von unten. Gut zu sehen sind die quer zur Bewegungsrichtung des Endlosbands 2 ausgerichteten Schienen 6 und 8, entlang derer der Düsenkopf/Druckkopf 5 beziehungsweise die Lichtquelle 7 bewegt werden können.

Ein Beispielhaftes Verfahren zum strukturierten Passivieren eines Endlosbandes 2 läuft nun wie folgt ab:
In einem ersten Schritt wird das Endlosband 2 zwischen den Umlenkrollen 3 und 4 (in den in den Figuren 1 sowie 3 und 4 gezeigten Beispielen) beziehungsweise zwischen den Umlenkrollen 3, 4, 9 und 10 (in dem in Fig. 2 gezeigten Beispiel) aufgespannt. In einem weiteren Schritt wird die Maske mit Hilfe des Düsenkopfes/Druckkopfes 5 auf das Endlosband 2 aufgetragen. Der Auftrag erfolgt im digitalen Strahldruckverfahren, vergleichbar mit dem Ausdrucken eines Bildes mit Hilfe eines Tintenstrahldruckers. Anstelle des Auftrags von Tinte auf Papier wird jedoch das Maskenmaterial auf das Endlosband aufgetragen. Die Maske besteht aus einem mit Licht härtbarem Maskenmaterial oder enthält zumindest solche mit Licht härtbaren Bestandteile. In einem weiteren Schritt wird die Maske mit Hilfe der Lichtquelle 7, welche zur Härtung des Maskenmaterials geeignet ist, bestrahlt.

Nach dem Auftragen und Härten der Maske kann die Oberfläche des Endlosbands 2 chemisch bearbeitet werden, insbesondere mit Eisen(III)-chlorid geätzt werden. Die Maske kann danach entfernt werden, und die Oberfläche des Endlosbands 2 kann auch veredelt werden. Beispielsweise kann die Oberfläche des Endlosbands 2 verchromt werden, wenn das Endlosband 2 aus Metall besteht. Auch eine Beschichtung mit diamantartigem Kohlenstoff oder mit Titanborid wäre denkbar.

Das Entfernen der Maske kann auch durch Ultraschall unterstützt oder bewirkt werden. Zur Vorbereitung des Maskenauftrags kann eine mechanische Säuberung und eine Reinigung des Endlosbands 2 mit Isopropanol, Ethanol oder Spiritus erfolgen und/oder eine Behandlung mit einem Primer, beispielsweise mit einer organischen Silyl-Verbindung. Vor dem Auftragen der Maske kann die Oberfläche des Endlosbands 2 auch geätzt werden. Im Speziellen kann auch eine stumpfe Oberfläche des Endlosbands 2 zur Vermeidung von Lichtreflexionen erzeugt werden.

Das Maskenmaterial kann beispielweise mit ultraviolettem Licht härtbar sein. Zu diesem Zweck strahlt die Lichtquelle 7 ultraviolettes Licht aus. Insbesondere kann das Maskenmaterial aus einem organischen Monomer bestehen, beispielsweise aus einem Wachs mit Pigmenten und UV-härtenden Bestandteilen, sowie reduzierte Lösungsmittelanteile enthalten.

Das Maskenmaterial kann aber auch mit infrarotem Licht härtbar sein. Dementsprechend strahlt die Lichtquelle 7 zum Härten der Maske dann infrarotes Licht aus.

Das Aushärten der Maske kann vorzugsweise in einem Zeitraum von bis zu 60 Sekunden nach dem Auftragen erfolgen. Das Maskenmaterial kann vor dem Auftragen zudem auch vorgewärmt werden vorzugsweise auf 50 °C bis 100 °C, insbesondere auf 65 °C bis 75 °C.

Die Lichtquelle 7 kann beispielsweise als Leuchtdiode, Quecksilberdampflampe, Xenonlampe, Laserdiode oder als Laser ausgebildet sein. Die Lichtquelle 7 kann kontinuierlich leuchten oder diskontinuierlich Licht aussenden, insbesondere gepulst oder in Form von Lichtblitzen. Die Belichtungszeiten der Lichtquelle 7 können frei steuerbar sein.

Vorteilhaft ist es auch, wenn sich die Farbe und/oder Transparenz der aufgetragenen Maske bei Bestrahlung mit der Lichtquelle 7 ändert. Die Farbe der Maske kann beispielsweise dunkler werden, wodurch sich die Sichtbarkeit und die Beurteilbarkeit des Auftrags durch einen Betrachter verbessert.

Der Düsenkopf/Druckkopf 5 kann mehrere entlang einer Linie, insbesondere entlang einer Geraden, angeordnete und in einem Düsenabstand voneinander beabstandete Düsen 11 aufweisen, die einzeln angesteuert werden (vergleiche auch Fig. 5). Insbesondere kann der Düsenabstand d=25 µm betragen. Der Düsenkopf/Druckkopf 5 kann aber auch mehrere in einem Düsenabstand d voneinander beabstandete Düsen 11 aufweisen, die in Form einer Matrix angeordnet sind und einzeln angesteuert werden (vergleiche auch Fig. 6). Insbesondere kann auch hier der Düsenabstand d=25µm betragen. eine Druckfrequenz des Düsenkopfs/Drucckopfs 5 kann im Speziellen zwischen 5 kHz und 40 kHz betragen, insbesondere im Wesentlichen 10 kHz.

Der Abstand vom Düsenkopf/Druckkopf 5 zum Endlosband 2 kann im Speziellen zwischen 1 und 5 mm betragen. Der Abstand von der Lichtquelle 7 zum Endlosband 2 kann im Speziellen zwischen 10 und 100 mm betragen. Der Abstand des Düsenkopfes/Druckkopfes 5 zum Endlosband 2 und/oder der Abstand der Lichtquelle 7 zum Endlosband 2 kann fix sein, oder es kann eine automatische Nivelliereinrichtung vorgesehen sein, welche den Düsenkopf/Drucckopf 5 und/oder die Lichtquelle 7 in einem gewählten und insbesondere veränderlichen Abstand zum Endlosband 2 führt.

In einer vorteilhaften Variante der Erfindung wird das Endlosband 2 während des Auftragens der Maske mit Hilfe der angetriebenen Umlenkrolle 3 in einer x-Richtung bewegt, und der Düsenkopf/Druckkopf 5 wird quer dazu, wie in der Fig. 4 dargestellt insbesondere rechtwinkelig dazu, in einer y-Richtung bewegt. In ganz analoger Weise wird das Endlosband 2 während der Bestrahlung der Maske mit Hilfe der der angetriebenen Umlenkrolle 3 in einer x-Richtung bewegt, und die Lichtquelle 7 wird quer dazu, im gezeigten Beispiel wiederum insbesondere rechtwinkelig dazu, in einer y-Richtung bewegt. Das Endlosband 2 bewegt sich beim Auftragen der Maske unter dem Düsenkopf/Druckkopf 5 und unter der Lichtquelle 7 durch. Eine Umlaufgeschwindigkeit des Endlosbandes 2 kann insbesondere zwischen 10 und 20 m/min betragen, vorteilhaft im Wesentlichen 15 m/min. Die Lichtquelle 7 ist in Bandbewegungsrichtung generell nach dem Düsenkopf/Druckkopf 5 angeordnet.

Der Auftrag der Maske (und auch die Bestrahlung derselben) kann in Zeilen A erfolgen, die in x-Richtung verlaufen, so wie dies im rechten Bereich des in Fig. 4 dargestellten Endlosbands 2 symbolisiert ist. Der Auftrag der Maske (und auch die Bestrahlung derselben) kann aber auch in Zeilen B erfolgen, die in y-Richtung verlaufen, so wie dies im mittleren Bereich des in Fig. 4 dargestellten Endlosbands 2 symbolisiert ist.

Das Auftragen der Maske und die Bestrahlung der Maske erfolgt vorteilhaft gleichzeitig, im Speziellen an unterschiedlichen Orten. Beispielsweise können das Auftragen der Maske und die Bestrahlung der Maske an derselben x-Position aber an unterschiedlichen y-Positionen erfolgen oder an unterschiedlichen x-Positionen aber an derselben y-Position oder an unterschiedlichen x-Positionen und unterschiedlichen y-Positionen. Letzterer Fall ist in der Fig. 4 dargestellt, und der Düsenkopf/Druckkopf 5 fährt etwas gegenüber der Lichtquelle 7 versetzt in Querrichtung y zur Bewegungsrichtung x des Endlosbands 2.

Generell können die Zeilen A, B ohne Überlappung nebeneinander aufgetragen werden. Ein Zeilenvorschub beträgt dann ein ganzzahliges Vielfaches des Düsenabstands d.

Denkbar ist aber auch, dass die Zeilen A, B einander überlappend aufgetragen werden, so wie dies in der Fig. 5 dargestellt ist. In diesem Beispiel beträgt die Überlappung rund zwei Drittel einer Zeilenhöhe h, beziehungsweise beträgt ein Zeilenvorschub rund ein Drittel der Zeilenhöhe h. Konkret wird in einem ersten Durchlauf eine erste Zeile A1 der Maske aufgetragen, die in der Fig. 5 symbolisiert mit durchgezogenen Linien dargestellt ist. Der Düsenkopf/Druckkopf 51 befindet sich dabei in der linken in Fig. 5 dargestellten Position.

In einem zweiten Durchlauf wird der Düsenkopf/Druckkopf 51 um ein Drittel der Zeilenhöhe h plus ein Drittel des Düsenabstands d der Düsen 11 verschoben. Der Zeilenvorschub beträgt somit ein nicht ganzzahliges Vielfaches des Düsenabstands d. Der Düsenkopf/Drucckopf 51 befindet sich dabei in der mittleren in Fig. 5 dargestellten Position. In dieser Position wird eine weitere Zeile A2 aufgetragen, welche zu der ersten Zeile A1 versetzt ist und in der Fig. 5 mit strichlierten Linien dargestellt ist.

In einem dritten Durchlauf wird der Düsenkopf/Druckkopf 51 um ein weiteres Drittel der Zeilenhöhe h plus ein weiteres Drittel des Düsenabstands d der Düsen 11 verschoben. Der Düsenkopf/Druckkopf 51 befindet sich dann in der rechten in Fig. 5 dargestellten Position. In dieser Position wird eine weitere Zeile A3 aufgetragen, welche zu der ersten Zeile A2 versetzt ist und in der Fig. 5 mit punktierten Linien dargestellt ist.

In der Fig. 5 ist der Düsenkopf/Druckkopf 51 auch mit dünnen Linien dargestellt. Diese Positionen kennzeichnen Positionen des Düsenkopfes/Druckkopfes 51 zu früheren Zeitpunkten, um anzudeuten, dass der Aufbau der Maske ein kontinuierlicher Prozess ist. In der Fig. 5 wurde der Zeilenaufbau für in x-Richtung verlaufende Zeilen A1..A3 beschrieben. In analoger Weise können natürlich auch Zeilen B aufgebaut werden, die in y-Richtung verlaufen. Die Düsen 11 des Düsenkopfes/Druckkopfes 51 können generell wiederum gleichzeitig oder hintereinander aktiviert werden.

Vorteilhaft ist es bei einem überlappenden Auftrag der Zeilen A, B, wenn eine Druckfrequenz respektive Ausstoßfrequenz auf den Reziprokwert des Zeilenvorschubs gesteigert wird. Beträgt der Zeilenvorschub beispielsweise 1/3, dann wird die Druckfrequenz/Ausstoßfrequenz auf den gegenüber dem nicht-überlappenden Auftrag der der Zeilen A, B auf das Dreifache gesteigert. Werden nicht-überlappende Zeilen A, B beispielsweise mit einer Druckfrequenz/Ausstoßfrequenz von 5 kHz aufgetragen, dann erfolgt der Auftrag bei einem Zeilenvorschub von rund 1/3 vorteilhaft bei einer Druckfrequenz/Ausstoßfrequenz von 15 kHz. Auf diese Weise bleibt die Auftragsgeschwindigkeit und damit die Zeit, welche vom Auftrag des Maskenmaterials bis zu dessen Härtung vergeht, gleich.

Fig. 6 zeigt ein Beispiel für einen Düsenkopf/Druckkopf 52 mit matrixförmig angeordneten Düsen 11. Dieser kann beispielsweise anstelle des Düsenkopfes/Druckkopfes 52 für das zu Fig. 5 beschriebenen Verfahren eingesetzt werden. Die Düsen 11 können generell wiederum gleichzeitig oder hintereinander aktiviert werden.

Generell ist auch denkbar, dass eine zufällige Auswahl der Düse 11 aus der Matrix zum Auftragen eines vorgegebenen Punktes der Maske erfolgt, wobei diese Düse 11, wenn sie den Auftragsbereich überstreicht, den Punkt druckt. Es kann auch vorgesehen sein, dass mehr als eine zufällig ausgewählte Düse 11 Maskenmaterial auf demselben Punkt aufträgt.

Zudem ist auch vorstellbar, dass die Düsen 11 unterschiedliches Maskenmaterial auftragen, was insbesondere bei Anwendung eines matrixförmigen Düsenkopfes/Druckkopfes 52 gut möglich ist. Beispielsweise tragen Düsen 11 einer ersten Spalte ein erstes Maskenmaterial auf, die Düsen 11 einer zweiten Spalte ein zweites Maskenmaterial und so weiter.

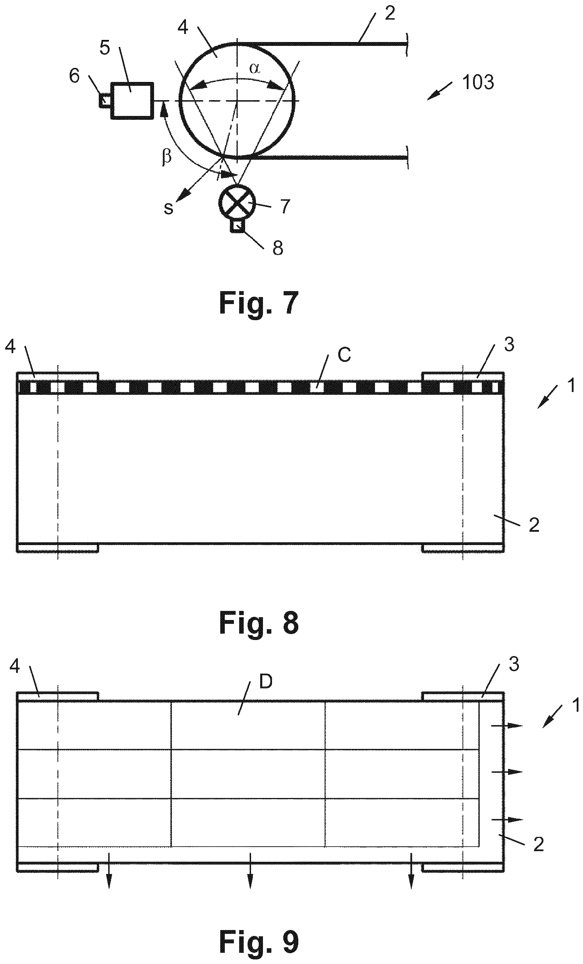

Fig. 7 zeigt einen etwas detaillierten Ausschnitt aus der in den Figuren 3 und 4 dargestellten Vorrichtung 103. Konkret ist in der Fig. 7 der Öffnungswinkel α der von der Lichtquelle 7 ausgestrahlten Lichtstrahlen s eingezeichnet. Aus der Fig. 7 ist erkennbar, dass kein von der Lichtquelle 7 ausgehender Lichtstrahl s direkt oder nach einfacher Reflexion am Endlosband 2 in eine Düse 11 des Düsenkopfs/Druckkopfs 15 führt. Rein beispielhaft ist dazu der im Winkel α/2 von der Lichtquelle 7 ausgehende Lichtstrahl s in der Fig. 7 eingezeichnet.

Dazu trägt auch der Umstand bei, dass eine mittlere Strahlrichtung des Düsenkopfes/Drucckopfes 5 und eine mittlere Strahlrichtung der Lichtquelle 7 in diesem Beispiel einen Winkel β=90° einschließen. Durch die räumliche Trennung des Düsenkopfes/Druckkopfes 5 von der Lichtquelle 7 wird verhindert, dass das Maskenmaterial bereits unbeabsichtigt im Düsenkopf/Druckkopf 5 gehärtet wird. Der Winkel von 90° ist dazu aber nicht zwingend vorgesehen. Weitere bevorzugte Werte sind auch zumindest 45°, zumindest 135° und im Wesentlichen 180°, das heißt zumindest 170°.

Im Bereich der Lichtquelle 7 kann auch eine Abdeckung oder Abschirmung vorgesehen sein, um die Beleuchtung unerwünschter Areale des Endlosbands 2, den Austritt von Licht aus einem gesicherten Bereich und/oder die Beleuchtung des Düsenkopfes/Druckkopfes 5 zu verhindern.

Vorteilhaft ist es in diesem Zusammenhang auch, wenn die Lichtquelle 7 nur dann Licht ausstrahlt, wenn der Düsenkopf/Druckkopf 5 Maskenmaterial auf das Endlosband 2 aufträgt. Durch den fortlaufenden Ausstoß von Maskenmaterial ist eine Härtung durch vagabundierendes, von der Lichtquelle 7 stammendes Licht praktisch ausgeschlossen.

Die Lichtquelle 7 kann auch ausgeschaltet werden, wenn sich diese in der Nähe des Düsenkopfes/Druckkopfes 5 befindet, um eine unerwünschte Härtung des Maskenmaterials im Düsenkopf/Druckkopf 5 zu vermeiden.

Vorteilhaft ist eine Wellenlänge des Strahlungsmaximums im emittierten Spektrum der Lichtquelle 7 auf eine Wellenlänge der maximalen spektralen Absorption des Endlosbands 2 abgestimmt. Insbesondere kann auch vorgesehen sein, dass wenigstens 90% des von der Lichtquelle ausgestrahlten Lichts vom Endlosband 2 absorbiert wird und/oder dass jeder von der Lichtquelle 7 ausgehende Lichtstrahl s auf das Endlosband 2 trifft und insbesondere zur Gänze durch die Oberfläche des Endlosbands 2 absorbiert wird.

Ist eine Lichtquelle 7 mit einer erforderlichen spektralen Verteilung nicht verfügbar oder technisch schwer realisierbar, so können auch Filter vorgesehen sein, welche das von der Lichtquelle 7 ausgestrahlte Licht durchläuft, um das Lichtspektrum in gewünschter Weise anzupassen. Insbesondere kann ein Lichtfilter eingesetzt werden, der kurzwelliges Licht nicht passieren lässt, wobei die Absorptionskante so gewählt ist, dass das passierende Licht vollständig vom Material des Endlosbandes 2 absorbiert wird.

Fig. 8 zeigt nun ein Beispiel für ein Endlosband 2 mit einer im Randbereich aufgetragenen oder aufgedruckten Maßverkörperung C. Diese Maßverkörperung C wird vor dem Auftragen der Maske auf das Endlosband 2 aufgetragen und dient dazu, temporäre Längenänderungen des Endlosbands 2 während dem Auftragen der Maske erkennen und ausgleichen zu können. Solche Längenänderungen können vom Antrieb der Umlenkrolle 3 herrühren. Beispielsweise können Getriebespiel und/oder von einer Antriebsregelung herrührende Drehmomentstöße Schwingungen in das Metallband 2 induzieren, die in Folge zu einer Abweichung der aufgetragenen Ist-Maske von einer gewünschten Soll-Maske führen können. Ein weiterer Grund für eine Abweichung der Ist-Maske von der gewünschten Soll-Maske kann auch darin begründet sein, dass das Endlosband 2 auf der angetriebenen Umlenkrolle 3 durchrutscht.

Mit Hilfe der Maßverkörperung C und eines (optischen) Sensors zur Erfassung der Maßverkörperung C können die genannten Längenänderungen erkannt werden, und der Düsenkopf/Druckkopf 5 kann dementsprechend geringfügig in x- und/oder y-Richtung verschoben werden. Die Maßverkörperung C kann insbesondere an die Länge des Endlosbands 2 angepasst sein, sodass diese endlos beziehungsweise nahtlos ist. Anstelle der Maßverkörperung C oder zusätzlich dazu kann auch eine einzelne Positionsmarke zur Kennzeichnung einer eindeutigen Position auf dem Endlosband 2 angebracht werden.

Das Verfahren umfasst im obigen Fall insbesondere die Schritte:
- Aufspannen des Endlosbandes 2 zwischen den Umlenkrollen 3, 4, 9, 10,
- Aufbringen und/oder Übertragen zumindest einer Maßverkörperung C auf das Endlosband 2, insbesondere auf eine Oberfläche des Endlosbandes 2;
- Erfassen der Position der Maßverkörperung C und/oder einer periodischen Teilung der Maßverkörperung C mittels zumindest eines Sensors;
- Erzeugen eines Signals zum Auftragen der Maske und Übermittlung an den Düsenkopf/Druckkopf 5, wenn die von dem zumindest einen Sensor erfasste Position der Maßverkörperung C auf der Oberfläche des Endlosbandes 2 einer Sollposition entspricht und/oder wenn der zumindest eine Sensor ein Ende oder einen Anfang einer Teilungsperiode der Maßverkörperung C detektiert;
- Ausstoßen von Tropfen des Maskenmaterials auf die Außenfläche des Endlosbandes 2 mittels des Düsenkopfes/Druckkopfes 5 nach Erhalt des Signals.

Denkbar ist auch, dass eine Vielzahl von einzelnen identen Strukturen D aneinandergereiht auf das Endlosband 2 aufgetragen werden, so wie das in der Fig. 9 dargestellt ist. Besonders vorteilhaft ist es in diesem Zusammenhang, wenn
- die Ist-Länge und/oder Ist-Breite des Endlosbands 2 bestimmt wird und
- eine Vielzahl von einzelnen identen Strukturen D aneinandergereiht auf das Endlosband 2 aufgetragen werden, wobei die Ist-Länge und/oder Ist-Breite des Endlosbands 2 durch eine Soll-Länge und/oder Soll-Breite der einzelnen Strukturen D dividiert und anschließend die Ist-Länge und/oder Ist-Breite der einzelnen Strukturen D auf einen ganzzahligen Bruchteil der Ist-Länge und/oder Ist-Breite des Endlosbands 2 angepasst wird das heißt proportional verändert wird. In dem in Fig. 9 dargestellten Beispiel sind die Soll-Strukturen D zu kurz und zu schmal um das Endlosband 2 nahtlos zu bedecken. Dementsprechend werden die Soll-Strukturen D so verlängert und verbreitert, dass die Ist-Strukturen das Endlosband 2 nahtlos bedecken, so wie das in der Fig. 9 mit den Pfeilen symbolisiert ist. In der Fig. 9 werden die Soll-Strukturen D verlängert und verbreitert. Denkbar ist aber natürlich auch, dass diese verkürzt werden und/oder deren Breite verringert wird.

Besonders vorteilhaft ist es auch, wenn die Maske unter Berücksichtigung einer zu erwartenden Dehnung des Endlosbands 2 in einem Betriebszustand aufgetragen wird. Das Endlosband 2 wird ja später beispielsweise in einer Bandgießanlage oder in einer Doppelbandpresse eingesetzt, in der das Endlosband zum Teil unter vergleichsweise hohe Zugspannungen gesetzt wird und sich dementsprechend dehnt. Damit einhergehend ist auch eine Dehnung der auf das Endlosband 2 aufgebrachten Struktur D, welche unter Umständen unerwünscht ist. Dementsprechend kann der spätere, zu erwartende Betriebszustand beim Auftragen der Maske auf das Endlosband 2 berücksichtigt werden.

Beispielsweise kann dies dadurch erfolgen, dass das Auftragen der Maske bei der im Wesentlichen gleichen Zugbeanspruchung des Endlosbands 2 erfolgt wie die zu erwartende spätere Zugebeanspruchung im späteren Betrieb des Endlosbands 2. Das heißt die Zugbeanspruch und damit die Dehnung des Endlosbands 2 sind beim Auftragen der Maske und im späteren Betrieb in etwa gleich. Denkbar ist aber auch, dass das Auftragen der Maske bei einer anderen Zugbeanspruchung des Endlosbands 2 erfolgt als die zu erwartende spätere Zugebeanspruchung im späteren Betrieb des Endlosbands 2, und unterschiedliche Dehnungen des Endlosbands 2 in den beiden Zuständen beim Auftragen der Maske berücksichtigt werden. Dementsprechend wird die Maske beim Auftragen etwas in die Länge gezogen, wenn die Zugspannung und damit die Dehnung des Endlosbands 2 beim Auftragen der Maske größer ist als im späteren Betrieb, oder die Maske wird beim Auftragen etwas verkürzt, wenn die Zugspannung und damit die Dehnung des Endlosbands 2 beim Auftragen der Maske kleiner ist als im späteren Betrieb. Die Dehnung des Endlosbands 2 kann beispielsweise anhand eines Querschnitts desselben berechnet werden.

In den Figuren ist das Endlosband 2 horizontal ausgerichtet, das heißt die Umlenkrollen 3 und 4 sind horizontal voneinander beabstandet. Selbstverständlich können die Umlenkrollen 3 und 4 auch vertikal voneinander beabstandet und das Endlosband 2 vertikal ausgerichtet sein.

Des Weiteren ist die Lichtquelle 7 bei den in den Figuren dargestellten Beispielen im Bereich einer Umlenkrolle 4, 10 angeordnet. Dies ist zwar vorteilhaft für die Erfindung, da der Abstand zwischen der Lichtquelle 7 und dem Endlosband 2 auch ohne spezielle Maßnahmen praktisch konstant ist, dennoch kann die Lichtquelle 7 auch zwischen zwei Umlenkrollen 3, 4, 9, 10 angeordnet sein. Das Endlosband 2 kann sich in diesem Bereich zwar grundsätzlich bewegen beziehungsweise schwingen, wodurch der Abstand zwischen der Lichtquelle 7 und dem Endlosband 2 nicht automatisch konstant ist, sondern sich ändert, jedoch spielt eine geringfügige Abstandsänderung für die Härtung des Maskenmaterials keine oder nur kaum eine Rolle.

In den Beispielen ist darüber hinaus ein Umschlingungswinkel der Umlenkrollen 3, 4, 9, 10 größer 0°. Dies trifft auch für das in der Fig. 2 dargestellte Beispiel zu. Denkbar wäre aber auch, dass der Umschlingungswinkel in dem in Fig. 2 dargestellte Fall 0° beträgt und im engeren Sinn nur eine Unterstützungsrolle vorliegt. Die Lichtquelle 7 ist dann zwischen den Umlenkrollen 3 und 4 im Bereich einer Unterstützungsrolle angeordnet.

Die Ausführungsbeispiele zeigen mögliche Ausführungsvarianten erfindungsgemäßer Vorrichtungen 1, 101..103, wobei an dieser Stelle bemerkt sei, dass die Erfindung nicht auf die speziell dargestellten Ausführungsvarianten derselben eingeschränkt ist, sondern auch andere Ausführungsvarianten möglich sind, deren Herleitung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Zum Beispiel besteht die aufgetragene Maske im Rahmen dieser Offenbarung aus einem mit Licht härtbarem Maskenmaterial oder umfasst wenigstens solche Bestandteile. Dennoch können einzelne Aspekte auch ohne diese Einschränkung angewandt werden und auch die Basis einer unabhängigen Erfindung bilden. Insbesondere betrifft dies die in den Ansprüchen 3-5, 9-23, 29, 31 oder 36 sowie die durch deren Kombinationen offenbarten Merkmale.

Ähnliches gilt für die Anordnung des Düsenkopfes/Druckkopfes 5, 51, 52 im Bereich einer Umlenkrolle 3, 4, 9, 10. Einzelne Aspekte der Offenbarung können auch ohne diese Einschränkung angewandt werden und auch die Basis einer unabhängigen Erfindung bilden. Insbesondere betrifft dies die in den Ansprüchen 2-27 und 30-37 sowie die durch deren Kombinationen offenbarten Merkmale.

Einzelne Merkmale der Offenbarung sind auch gänzlich ohne Verwendung eines Düsenkopfes/Druckkopfes 5, 51, 52 anwendbar, beziehungsweise können die Basis unabhängiger Erfindungen bilden. Insbesondere betrifft dies die in den Ansprüchen 2, 6-12, 15-27 und 30, 31, 33, 35 und 37 sowie die durch deren Kombinationen offenbarten Merkmale.

Insbesondere wird auch festgehalten, dass die dargestellten Anordnungen in der Realität auch mehr oder weniger Bestandteile als dargestellt umfassen können und in den Figuren bisweilen stark vereinfacht dargestellt sind.

Der Ordnung halber sei abschließend darauf hingewiesen, dass die dargestellten Vorrichtungen sowie ihre Bestandteile zum besseren Verständnis ihres Aufbaus darüber hinaus teilweise unmaßstäblich und/oder vergrößert und/oder verkleinert dargestellt wurden.

### Bezugszeichenaufstellung

- 1, 101..103: Vorrichtung zum strukturierten Passivieren eines Endlosbandes
- 2: Endlosband
- 3: erste Umlenkrolle
- 4: zweite Umlenkrolle
- 5, 51, 52: Düsenkopf/Druckkopf

- 6: Schiene für Düsenkopf/Druckkopf
- 7: Lichtquelle
- 8: Schiene für Lichtquelle
- 9: dritte Umlenkrolle
- 10: vierte Umlenkrolle
- 11: Düse

- d: Düsenabstand
- h: Zeilenhöhe
- s: Lichtstrahl

- A: Zeile in Längsrichtung des Endlosbands verlaufend
- B: Zeile in Querrichtung des Endlosbands verlaufend
- C: Maßverkörperung
- D: Struktur

- α: Öffnungswinkel der Lichtquelle
- β: Winkel zwischen dem Düsenkopf/Druckkopf und der Lichtquelle

## Patentansprüche

1. Verfahren zum strukturierten Passivieren eines Endlosbandes (2), umfassend die Schritte
- Aufspannen des Endlosbandes (2) zwischen zumindest zwei Umlenkrollen (3, 4, 9, 10), von denen wenigstens eine angetrieben ist,
- Auftragen einer Maske auf das Endlosband (2) zur strukturierten Passivierung desselben mit Hilfe eines Düsenkopfes/Druckkopfes (5, 51, 52) im digitalen Strahldruckverfahren, wobei die aufgetragene Maske aus einem mit Licht härtbarem Maskenmaterial besteht oder zumindest solche Bestandteile enthält, und
- zumindest teilweise Bestrahlung der Maske mittels einer zur Härtung geeigneten Lichtquelle (7) nach der Auftragung,
**dadurch gekennzeichnet, dass**
- das Auftragen der Maske auf das Endlosband (2) im Bereich einer Umlenkrolle (3, 4, 9, 10) erfolgt und
- vor dem Auftragen der Maske eine Positionsmarke und/oder eine an die Länge des Endlosbands (2) angepasste Maßverkörperung (C) auf das Endlosband (2) aufgebracht wird.

2. Verfahren nach Anspruch 1, **dadurch gekennzeichnet, dass**
- das Maskenmaterial mit ultraviolettem Licht härtbar ist und die Lichtquelle (7) ultraviolettes Licht ausstrahlt oder
- das Maskenmaterial mit infrarotem Licht härtbar ist und die Lichtquelle (7) infrarotes Licht ausstrahlt.

3. Verfahren nach Anspruch 1 oder 2, **dadurch gekennzeichnet, dass** der Düsenkopf/Druckkopf (5, 51, 52) mehrere entlang einer Linie angeordnete und in einem Düsenabstand (d) voneinander beabstandete Düsen (11) aufweist, die einzeln angesteuert werden.

4. Verfahren nach Anspruch 1 oder 2, **dadurch gekennzeichnet, dass** der Düsenkopf/Druckkopf (5, 51, 52) mehrere in einem Düsenabstand (d) voneinander beabstandete Düsen (11) aufweist, die in Form einer Matrix angeordnet sind und einzeln angesteuert werden.

5. Verfahren nach einem der Ansprüche 1 bis 4, **dadurch gekennzeichnet, dass** das Endlosband (2) während des Auftragens der Maske mit Hilfe der zumindest einen angetriebenen Umlenkrolle (3, 4, 9, 10) in einer x-Richtung bewegt wird und der Düsenkopf/Druckkopf (5, 51, 52) quer dazu in einer y-Richtung bewegt wird.

6. Verfahren nach einem der Ansprüche 1 bis 5, **dadurch gekennzeichnet, dass** das Endlosband (2) während der Bestrahlung der Maske mit Hilfe der zumindest einen angetriebenen Umlenkrolle (3, 4, 9, 10) in einer x-Richtung bewegt wird und die Lichtquelle (7) quer dazu in einer y-Richtung bewegt wird.

7. Verfahren nach einem der Ansprüche 1 bis 6, **dadurch gekennzeichnet, dass** das Auftragen der Maske und die Bestrahlung der Maske gleichzeitig erfolgt.

8. Verfahren nach einem der Ansprüche 1 bis 7, **dadurch gekennzeichnet, dass** das Auftragen der Maske und die Bestrahlung der Maske an unterschiedlichen Orten erfolgt.

9. Verfahren nach einem der Ansprüche 5 bis 8, **dadurch gekennzeichnet, dass** die Maske in Zeilen (A, A1..A3) aufgetragen wird, die in x-Richtung verlaufen.

10. Verfahren nach einem der Ansprüche 5 bis 8, **dadurch gekennzeichnet, dass** die Maske in Zeilen (B) aufgetragen wird, die in y-Richtung verlaufen.

11. Verfahren nach einem der Ansprüche 1 bis 10, **dadurch gekennzeichnet, dass** die Zeilen (A, B) ohne Überlappung nebeneinander aufgetragen werden.

12. Verfahren nach einem der Ansprüche 1 bis 10, **dadurch gekennzeichnet, dass** die Zeilen (A, A1..A3, B) einander überlappend aufgetragen werden.

13. Verfahren nach einem der Ansprüche 9 bis 12, **dadurch gekennzeichnet, dass** ein Zeilenvorschub ein ganzzahliges Vielfaches des Düsenabstands (d) beträgt.

14. Verfahren nach einem der Ansprüche 9 bis 12, **dadurch gekennzeichnet, dass** ein Zeilenvorschub ein nicht ganzzahliges Vielfaches des Düsenabstands (d) beträgt.

15. Verfahren nach einem der Ansprüche 1 bis 14, **dadurch gekennzeichnet, dass**
- die Ist-Länge und/oder Ist-Breite des Endlosbands (2) bestimmt wird und
- eine Vielzahl von einzelnen identen Strukturen (D) aneinandergereiht auf das Endlosband (2) aufgetragen werden, wobei die Ist-Länge und/oder Ist-Breite des Endlosbands (2) durch eine Soll-Länge und/oder Soll-Breite der einzelnen Strukturen (D) dividiert und anschließend die Ist-Länge und/oder Ist-Breite der einzelnen Strukturen (D) auf einen ganzzahligen Bruchteil der Ist-Länge und/oder Ist-Breite des Endlosbands (2) angepasst wird, das heißt proportional verändert wird.

16. Verfahren nach einem der Ansprüche 1 bis 15, **dadurch gekennzeichnet, dass** das Auftragen der Maske unter Berücksichtigung einer zu erwartenden Dehnung des Endlosbands (2) in einem Betriebszustand erfolgt.

17. Verfahren nach Anspruch 16, **dadurch gekennzeichnet, dass** das Auftragen der Maske bei der im Wesentlichen gleichen Zugbeanspruchung des Endlosbands (2) erfolgt wie die zu erwartende spätere Zugebeanspruchung im späteren Betrieb des Endlosbands (2).

18. Verfahren nach Anspruch 16, **dadurch gekennzeichnet, dass** das Auftragen der Maske bei einer anderen Zugbeanspruchung des Endlosbands (2) erfolgt als die zu erwartende spätere Zugebeanspruchung im späteren Betrieb des Endlosbands (2), und unterschiedliche Dehnungen des Endlosbands (2) in den beiden Zuständen beim Auftragen der Maske berücksichtigt werden.

19. Verfahren nach Anspruch 18, **dadurch gekennzeichnet, dass** die Dehnung des Pressbandes anhand eines Querschnitts des Endlosbands (2) berechnet wird.

20. Verfahren nach einem der Ansprüche 1 bis 19, **dadurch gekennzeichnet, dass** das Maskenmaterial aus einem organischen Monomer besteht.

21. Verfahren zur Oberflächenstrukturierung eines Endlosbandes (2), **dadurch gekennzeichnet, dass** die Oberfläche des Endlosbands (2) nach Durchführung eines Verfahrens nach einem der Ansprüche 1 bis 20 chemisch bearbeitet wird.

22. Verfahren nach einem der Ansprüche 1 bis 19, **dadurch gekennzeichnet, dass** eine Umlaufgeschwindigkeit des Endlosbandes (2) zwischen 10 und 20 m/min beträgt.

23. Verfahren nach einem der Ansprüche 1 bis 22, **dadurch gekennzeichnet, dass** die Lichtquelle (7) kontinuierlich leuchtet oder diskontinuierlich Licht aussendet.

24. Verfahren nach einem der Ansprüche 1 bis 23, **dadurch gekennzeichnet, dass** wenigstens 90% des von der Lichtquelle (7) ausgestrahlten Lichts vom Endlosband (2) absorbiert wird.

25. Verfahren nach einem der Ansprüche 1 bis 24, **dadurch gekennzeichnet, dass** sich die Farbe und/oder Transparenz der aufgetragenen Maske bei Bestrahlung mit der Lichtquelle (7) ändert.

26. Verfahren nach einem der Ansprüche 1 bis 25, **dadurch gekennzeichnet, dass** eine Wellenlänge des Strahlungsmaximums im emittierten Spektrum der Lichtquelle (7) auf eine Wellenlänge der maximalen spektralen Absorption des Endlosbands (2) abgestimmt ist.

27. Vorrichtung (1, 101..103) zum strukturierten Passivieren eines Endlosbandes (2), umfassend
- zumindest zwei Umlenkrollen (3, 4, 9, 10), von denen wenigstens eine angetrieben ist und zwischen denen das Endlosband (2) spannbar ist,
- einen Düsenkopf/Druckkopf (5, 51, 52), welcher zum Auftragen einer Maske auf das Endlosband (2) im digitalen Strahldruckverfahren ausgebildet ist, und
- eine im Bereich einer Umlenkrolle (3, 4, 9, 10) oder zwischen den Umlenkrollen (3, 4, 9, 10) angeordnete Lichtquelle (7),
**dadurch gekennzeichnet, dass**
- der Düsenkopf/Druckkopf (5, 51, 52) im Bereich einer Umlenkrolle (3, 4, 9, 10) angeordnet ist und
- ein Sensor zur Erfassung einer auf das Endlosband (2) aufgebrachten Positionsmarke und/oder einer an die Länge des Endlosbands (2) angepassten Maßverkörperung (C) vorgesehen ist.

28. Vorrichtung (1, 101..103) nach Anspruch 27, **dadurch gekennzeichnet, dass** der Düsenkopf/Druckkopf (5, 51, 52) im Bereich des Scheitelpunkts der Umlenkrolle (3, 4, 9, 10) angeordnet ist und eine Strahlrichtung des Düsenkopfes/Druckkopfes (5, 51, 52) in einem Bereich von +/- 10° um eine horizontale Richtung ausgerichtet ist.

29. Vorrichtung (1, 101..103) nach Anspruch 27 oder 28, **dadurch gekennzeichnet, dass** die Lichtquelle (7) Bereich der Umlenkrolle (3, 4, 9, 10) angeordnet ist und eine mittlere Leuchtrichtung in einem Bereich von +/- 10° um eine vertikale Richtung ausgerichtet ist.

30. Vorrichtung (1, 101..103) nach einem der Ansprüche 27 bis 29, **dadurch gekennzeichnet, dass** der Abstand vom Düsenkopf/Druckkopf (5, 51, 52) zum Endlosband (2) zwischen 1 und 5 mm und der Abstand von der Lichtquelle (7) zum Endlosband (2) zwischen 10 und 100 mm beträgt.

31. Vorrichtung (1, 101..103) nach einem der Ansprüche 27 bis 30, **dadurch gekennzeichnet, dass** kein von der Lichtquelle (7) ausgehender Lichtstrahl (s) direkt oder nach einfacher Reflexion am Endlosband (2) in eine Düse (11) des Düsenkopfs/Druckkopfs (5, 51, 52) führt.

32. Vorrichtung (1, 101..103) nach Anspruch 31, **dadurch gekennzeichnet, dass** jeder von der Lichtquelle (7) ausgehende Lichtstrahl (s) auf das Endlosband (2) trifft.

33. Vorrichtung (1, 101..103) nach einem der Ansprüche 27 bis 33, **dadurch gekennzeichnet, dass** eine mittlere Strahlrichtung des Düsenkopfes/Druckkopfes (5, 51, 52) und eine mittlere Strahlrichtung der Lichtquelle (7) einen Winkel (ß) von zumindest 45° einschließen.

34. Vorrichtung (1, 101..103) nach einem der Ansprüche 27 bis 33, **dadurch gekennzeichnet, dass** ein Strahlungsmaximum der Lichtquelle (7) im emittierten Spektrum auf eine Wellenlänge in einem Bereich um die maximale Absorption des Endlosbands (2) abgestimmt ist.

35. Vorrichtung nach einem der Ansprüche 37 bis 34, **dadurch gekennzeichnet, dass** eine Ausdruckfrequenz des Düsenkopfs/Druckkopfs (5, 51, 52) zwischen 5 kHz und 40 kHz beträgt.

36. Vorrichtung nach einem der Ansprüche 27 bis 35, **dadurch gekennzeichnet, dass** die Lichtquelle (7) als Leuchtdiode, Quecksilberdampflampe, Xenonlampe, Laserdiode oder als Laser ausgebildet ist.

37. Vorrichtung nach einem der Ansprüche 27 bis 36, **dadurch gekennzeichnet, dass** der Düsenkopf/Druckkopf (5, 51, 52) im Bereich einer ersten Umlenkrolle (3, 9) und die Lichtquelle (7) im Bereich einer von der ersten Umlenkrolle (3, 9) beabstandeten zweiten Umlenkrolle (4, 10) angeordnet ist.

38. Vorrichtung nach einem der Ansprüche 27 bis 36, **dadurch gekennzeichnet, dass** der Düsenkopf/Druckkopf (5, 51, 52) und die Lichtquelle (7) im Bereich derselben Umlenkrolle (4) angeordnet sind.

## Claims

1. A method for the structured passivation of an endless belt (2), comprising the steps
- spanning the endless belt (2) between at least two deflection rollers (3, 4, 9, 10), at least one of which is driven,
- applying a mask onto the endless belt (2) for the structured passivation of the same with the aid of a nozzle head/print head (5, 51, 52) using the digital jet printing method, wherein the applied mask is made of a light-curable mask material or at least contains such components, and
- at least partially irradiating the mask by means of a light source (7) suitable for curing after the application,
**characterized in that**
- the application of the mask onto the endless belt (2) takes place in the region of a deflection roller (3, 4, 9, 10) and
- before applying the mask, a positional mark and/or a measuring standard (C) adjusted to the length of the endless belt (2) is applied to the endless belt (2).

2. The method according to claim 1, **characterized in that**
- the mask material is curable by ultraviolet light, and the light source (7) emits ultraviolet light, or
- the mask material is curable by infrared light, and the light source (7) emits infrared light.

3. The method according to claim 1 or 2, **characterized in that** the nozzle head/print head (5, 51, 52) has multiple nozzles (11) arranged in a line and spaced apart from one another at a nozzle distance (d), which nozzles (11) are actuated individually.

4. The method according to claim 1 or 2, **characterized in that** the nozzle head/print head (5, 51, 52) has multiple nozzles (11) spaced apart from one another at a nozzle distance (d), which nozzles (11) are arranged in the form of a matrix and are actuated individually.

5. The method according to one of claims 1 to 4, **characterized in that**, during the application of the mask, the endless belt (2) is moved in an x-direction with the aid of the at least one driven deflection roller (3, 4, 9, 10), and the nozzle head/print head (5, 51, 52) is moved transversely thereto in a y-direction.

6. The method according to one of claims 1 to 5, **characterized in that**, during the irradiation of the mask, the endless belt (2) is moved in an x-direction with the aid of the at least one driven deflection roller (3, 4, 9, 10), and the light source (7) is moved transversely thereto in a y-direction.

7. The method according to one of claims 1 to 6, **characterized in that** the application of the mask and the irradiation of the mask take place simultaneously.

8. The method according to one of claims 1 to 7, **characterized in that** the application of the mask and the irradiation of the mask take place at different locations.

9. The method according to one of claims 5 to 8, **characterized in that** the mask is applied in lines (A, A1..A3) running in the x-direction.

10. The method according to one of claims 5 to 8, **characterized in that** the mask is applied in lines (B) running in the y-direction.

11. The method according to one of claims 1 to 10, **characterized in that** the lines (A, B) are applied next to one another without overlapping.

12. The method according to one of claims 1 to 10, **characterized in that** the lines (A, A1...A3, B) are applied so as to overlap one another.

13. The method according to one of claims 9 to 12, **characterized in that** a line feed amounts to an integral multiple of the nozzle distance (d).

14. The method according to one of claims 9 to 12, **characterized in that** a line feed amounts to a non-integral multiple of the nozzle distance (d).

15. The method according to one of claims 1 to 14, **characterized in that**
- the actual length and/or actual width of the endless belt (2) is determined, and
- a plurality of individual, identical structures (D) are applied in a row onto the endless belt (2), wherein the actual length and/or actual width of the endless belt (2) is divided by a target length and/or target width of the individual structures (D), and subsequently, the actual length and/or actual width of the individual structures (D) is adjusted to an integral fraction of the actual length and/or actual width of the endless belt (2), meaning it is proportionally changed.

16. The method according to one of claims 1 to 15, **characterized in that** the application of the mask takes place with consideration of a stretching of the endless belt (2) expected in an operating state.

17. The method according to claim 16, **characterized in that** the application of the mask takes place at substantially the same tensile stress of the endless belt (2) as the tensile stress to be expected later during operation of the endless belt (2).

18. The method according to claim 16, **characterized in that** the application of the mask takes place at a different tensile stress of the endless belt (2) than the tensile stress to be expected later during the operation of the endless belt (2), and different degrees of stretching of the endless belt (2) in the two states are taken into consideration during the application of the mask.

19. The method according to claim 18, **characterized in that** the stretching of the pressing belt is calculated based on a cross-section of the endless belt (2).

20. The method according to one of claims 1 to 19, **characterized in that** mask material consists of an organic monomer.

21. A method for the surface structuring of an endless belt (2), **characterized in that** the surface of the endless belt (2) is chemically processed after the performance of a method according to one of claims 1 to 20.

22. The method according to one of claims 1 to 19, **characterized in that** a circulation speed of the endless belt (2) is between 10 and 20 m/min.

23. The method according to one of claims 1 to 22, **characterized in that** the light source (7) continuously glows or discontinuously emits light.

24. The method according to one of claims 1 to 23, **characterized in that** at least 90 % of the light emitted by the light source (7) is absorbed by the endless belt (2).

25. The method according to one of claims 1 to 24, **characterized in that** the color and/or transparency of the applied mask changes upon irradiation by a light source (7).

26. The method according to one of claims 1 to 25, **characterized in that** a wavelength of the radiation maximum in the emitted spectrum of the light source (7) is adapted to a wavelength of the maximum spectral absorption of the endless belt (2).

27. A device (1, 101..103) for the structured passivation of an endless belt (2), comprising
- at least two deflection rollers (3, 4, 9, 10), at least one of which is driven and between which the endless belt (2) can be spanned,
- a nozzle head/print head (5, 51, 52) which is designed to apply a mask to the endless belt (2) in the digital jet printing method, and
- a light source (7) arranged in the region of a deflection roller (3, 4, 9, 10) or between the deflection rollers (3, 4, 9, 10),
**characterized in that**
- the nozzle head/print head (5, 51, 52) is arranged in the region of a deflection roller (3, 4, 9, 10), and
- a sensor for detecting a positional mark applied to the endless belt (2) and/or a measuring standard (C) adjusted to the length of the endless belt (2).

28. The device (1, 101..103) according to claim 27, **characterized in that** the nozzle head/print head (5, 51, 52) is arranged in the region of the vertex of the deflection roller (3, 4, 9, 10), and a radiation jet direction of the nozzle head/print head (5, 51, 52) is oriented in a region of +/- 10° about a horizontal direction.

29. The device (1, 101..103) according to claim 27 or 28, **characterized in that** the light source (7) is arranged in the region of the deflection roller (3, 4, 9, 10), and an average light direction is oriented in a region of +/- 10° about a vertical direction.

30. The device (1, 101..103) according to one of claims 27 to 29, **characterized in that** the distance between the nozzle head/print head (5, 51, 52) and the endless belt (2) is between 1 and 5 mm, and the distance between the light source (7) and the endless belt (2) is between 10 and 100 mm.

31. The device (1, 101..103) according to one of claims 27 to 30, **characterized in that** no light beam (s) starting from the light source (7) leads into a nozzle (11) of the nozzle head/print head (5, 51, 52), either directly or after a single reflection on the endless belt (2).

32. The device (1, 101..103) according to claim 31, **characterized in that** every light beam (s) starting from the light source (7) hits the endless belt (2).

33. The device (1, 101..103) according to one of claims 27 to 33, **characterized in that** an average jet direction of the nozzle head/print head (5, 51, 52) and an average beam direction of the light source (7) form an angle (β) of at least 45°.

34. The device (1, 101..103) according to one of claims 27 to 33, **characterized in that** the radiation maximum of the light source (7) in the emitted spectrum is adapted to a wavelength in a range around the maximum absorption of the endless belt (2).

35. The device according to one of claims 37 to 34, **characterized in that** a printing frequency of the nozzle head/print head (5, 51, 52) is between 5 kHz and 40 kHz.

36. The device according to one of claims 27 to 35, **characterized in that** the light source (7) is configured as a light-emitting diode, mercury vapor lamp, xenon lamp, laser diode or as a laser.

37. The device according to one of claims 27 to 36, **characterized in that** the nozzle head/print head (5, 51, 52) is arranged in the region of a first deflection roller (3, 9), and the light source (7) is arranged in the region of a second deflection roller (4, 10) spaced apart from the first deflection roller (3, 9).

38. The device according to one of claims 27 to 36, **characterized in that** the nozzle head/print head (5, 51, 52) and the light source (7) are arranged in the region of the same deflection roller (4).

## Revendications

1. Procédé de passivation structurée d'une bande sans fin (2), comprenant les étapes suivantes
- serrage de la bande sans fin (2) entre au moins deux galets de renvoi (3, 4, 9, 10) dont au moins un est entraîné,
- application d'un masque sur la bande sans fin (2) pour la passivation structurée de celle-ci à l'aide d'une tête de buse / tête d'impression (5, 51, 52) dans un procédé d'impression par jet d'encre numérique, dans lequel le masque appliqué est constitué d'un matériau de masque durcissable à la lumière ou contient au moins de tels composants et
- irradiation au moins partielle du masque au moyen d'une source de lumière (7) adaptée au durcissement après l'application,
**caractérisé en ce que**
- l'application du masque sur la bande sans fin (2) a lieu au niveau d'un galet de renvoi (3, 4, 9, 10) et
- avant l'application du masque, un repère de position et/ou une graduation (C) adaptée à la longueur de la bande sans fin (2) est appliquée sur la bande sans fin (2).

2. Procédé selon la revendication 1, **caractérisé en ce que**
- le matériau du masque peut être durci avec une lumière ultraviolette et la source de lumière (7) émet une lumière ultraviolette ou
- le matériau du masque peut être durci avec une lumière infrarouge et la source de lumière (7) émet une lumière infrarouge.

3. Procédé selon la revendication 1 ou 2, **caractérisé en ce que** la tête de buse / tête d'impression (5, 51, 52) comprend plusieurs buses (11) disposées le long d'une ligne et distantes entre elles avec une distance entre les buses (d) et sont contrôlées individuellement.

4. Procédé selon la revendication 1 ou 2, **caractérisé en ce que** la tête de buse / tête d'impression (5, 51, 52) comprend plusieurs buses (11) distantes entre elles avec une distance entre les buses (d), qui sont disposées sous la forme d'une matrice et sont contrôlées individuellement.

5. Procédé selon l'une des revendications 1 à 4, **caractérisé en ce que** la bande sans fin (2) est déplacée, pendant l'application du masque, à l'aide de l'au moins un galet de renvoi entraîné (3, 4, 9, 10) dans une direction x et la tête de buse / tête d'impression (5, 51, 52) est déplacée transversalement par rapport à celui-ci dans une direction y.

6. Procédé selon l'une des revendications 1 à 5, **caractérisé en ce que** la bande sans fin (2) est déplacée, pendant l'irradiation du masque, à l'aide de l'au moins un galet de renvoi entraîné (3, 4, 9, 10) dans une direction x et la source de lumière (7) est déplacée transversalement par rapport à celui-ci dans une direction y.

7. Procédé selon l'une des revendications 1 à 6, **caractérisé en ce que** l'application du masque et l'irradiation du masque ont lieu simultanément.

8. Procédé selon l'une des revendications 1 à 7, **caractérisé en ce que** l'application du masque et l'irradiation du masque ont lieu à des endroits différents.

9. Procédé selon l'une des revendications 5 à 8, **caractérisé en ce que** le masque est appliqué en lignes (A, A1..A3) qui s'étendent dans la direction x.

10. Procédé selon l'une des revendications 5 à 8, **caractérisé en ce que** le masque est appliqué en lignes (B) qui s'étendent dans la direction y.

11. Procédé selon l'une des revendications 1 à 10, **caractérisé en ce que** les lignes (A, B) sont appliquées sans chevauchement les unes à côté des autres.

12. Procédé selon l'une des revendications 1 à 10, **caractérisé en ce que** les lignes (A, A1..A3, B) sont appliquées avec un chevauchement.

13. Procédé selon l'une des revendications 9 à 12, **caractérisé en ce qu'**un saut de ligne représente un multiple entier de la distance entre les buses (d).

14. Procédé selon l'une des revendications 9 à 12, **caractérisé en ce qu'**un saut de ligne représente un multiple non entier de la distance entre les buses (d).

15. Procédé selon l'une des revendications 1 à 14, **caractérisé en ce que**
- la longueur réelle et/ou la largeur réelle de la bande sans fin (2) est déterminée et
- une pluralité de structures individuelles identiques (D) sont appliquées de manière alignée sur la bande sans fin (2), dans lequel la longueur réelle et/ou la largeur réelle de la bande sans fin (2) est divisée par une longueur de consigne et/ou une largeur de consigne des structures individuelles (D) puis la longueur réelle et/ou la largeur réelle des structures individuelles (D) est adaptée à une fraction entière de la longueur réelle et/ou la largeur réelle de la bande sans fin (2), c'est-à-dire est modifiée de manière proportionnelle.

16. Procédé selon l'une des revendications 1 à 15, **caractérisé en ce que** l'application du masque a lieu en tenant compte d'une dilatation prévisible de la bande sans fin (2) dans un état de fonctionnement.

17. Procédé selon la revendication 16, **caractérisé en ce que** l'application du masque a lieu lors de la sollicitation en traction de la bande sans fin (2) globalement identique à la sollicitation en traction ultérieure prévisible dans le fonctionnement ultérieur de la bande sans fin (2).

18. Procédé selon la revendication 16, **caractérisé en ce que** l'application du masque a lieu lors de la sollicitation en traction de la bande sans fin (2) différente de la sollicitation en traction ultérieure prévisible dans le fonctionnement ultérieur de la bande sans fin (2) et des dilatations différentes de la bande sans fin (2) sont prises en compte dans les deux états lors de l'application du masque.

19. Procédé selon la revendication 18, **caractérisé en ce que** la dilatation de la bande de presse est calculée à l'aide d'une section transversale de la bande sans fin (2).

20. Procédé selon l'une des revendications 1 à 19, **caractérisé en ce que** le matériau du masque est constitué d'un monomère organique.

21. Procédé de structuration de surface d'une bande sans fin (2), **caractérisé en ce que** la surface de la bande sans fin (2) est traitée chimiquement après l'exécution d'un procédé selon l'une des revendications 1 à 20.

22. Procédé selon l'une des revendications 1 à 19, **caractérisé en ce qu'**une vitesse de circulation de la bande sans fin (2) est entre 10 et 20 m/min.

23. Procédé selon l'une des revendications 1 à 22, **caractérisé en ce que** la source de lumière (7) émet de la lumière de manière continue ou discontinue.

24. Procédé selon l'une des revendications 1 à 23, **caractérisé en ce qu'**au moins 90 % de la lumière émis par la source de lumière (7) est absorbée par la bande sans fin (2).

25. Procédé selon l'une des revendications 1 à 24, **caractérisé en ce que** la couleur et/ou la transparence du masque appliqué varie lors de l'irradiation avec la source de lumière (7).

26. Procédé selon l'une des revendications 1 à 25, **caractérisé en ce qu'**une longueur d'onde du maximum de rayonnement dans le spectre émis de la source de lumière (7) est adaptée à la longueur d'onde de l'absorption spectrale maximale de la bande sans fin (2).

27. Dispositif (1, 101 .. 103) pour la passivation structurée d'une bande sans fin (2), comprenant
- au moins deux galets de renvoi (3, 4, 9, 10) dont au moins un est entraînée et entre lesquels la bande sans fin (2) peu être serré,
- une tête de buse / tête d'impression (5, 51, 52) qui est conçue pour l'application d'un masque sur la bande sans fin (2) dans le procédé d'impression par jet d'encre numérique et
- une source de lumière (7) disposée au niveau d'un galet de renvoi (3, 4, 9, 10) ou entre les galets de renvoi (3, 4, 9, 10),
**caractérisé en ce que**
- la tête de buse / tête d'impression (5, 51, 52) est disposée au niveau d'un galet de renvoi (3, 4, 9, 10) et
- un capteur est prévu pour la détection d'un repère de position réalisé sur la bande sans fin (2) et/ou d'une graduation (C) adaptée à la longueur de la bande sans fin (2).

28. Dispositif (1, 101 .. 103) selon la revendication 27, **caractérisé en ce que** la tête de buse / tête d'impression (5, 51, 52) est disposée au niveau du sommet du galet de renvoi (3, 4, 9, 10) et une direction du rayonnement de la tête de buse / tête d'impression (5, 51, 52) est orientée dans une zone de ± 10° autour d'une direction horizontale.

29. Dispositif (1, 101 .. 103) selon la revendication 27 ou 28, **caractérisé en ce que** la source de lumière (7) est disposée au niveau du galet de renvoi (3, 4, 9, 10) et une direction d'éclairage centrale est orientée dans une zone de ± 10° autour d'une direction verticale.

30. Dispositif (1, 101 .. 103) selon l'une des revendications 27 à 29, **caractérisé en ce que** la distance entre la tête de buse / tête d'impression (5, 51, 52) et la bande sans fin (2) est entre 1 et 5 mm et la distance entre la source de lumière (7) et la bande sans fin (2) est entre 10 et 100 mm.

31. Dispositif (1, 101 .. 103) selon l'une des revendications 27 à 30, **caractérisé en ce qu'**aucun rayon lumineux (s) sortant de la source de lumière (7) ne conduit directement ou après une simple réflexion sur la bande sans fin (2) vers une buse (11) de la tête de buse / tête d'impression (5, 51, 52).

32. Dispositif (1, 101 .. 103) selon la revendication 31, **caractérisé en ce que** chaque rayon lumineux (s) sortant de la source de lumière (7) arrive sur la bande sans fin (2).

33. Dispositif (1, 101 .. 103) selon l'une des revendications 27 à 33, **caractérisé en ce qu'**une direction de rayonnement centrale de la tête de buse / tête d'impression (5, 51, 52) et une direction de rayonnement centrale de la source de lumière (7) forment un angle (β) d'au moins 45°.

34. Dispositif (1, 101 .. 103) selon l'une des revendications 27 à 33, **caractérisé en ce qu'**un maximum de rayonnement de la source de lumière (7) dans le spectre émis est adapté à une longueur d'onde dans une zone autour de l'absorption maximale de la bande sans fin (2).

35. Dispositif selon l'une des revendications 37 à 34, **caractérisé en ce qu'**une fréquence d'impression de la tête de buse / tête d'impression (5, 51, 52) est entre 5 kHz et 40 kHz.

36. Dispositif selon l'une des revendications 27 à 35, **caractérisé en ce que** la source de lumière (7) est conçue comme une diode électroluminescente, une lampe à vapeur de mercure, une lampe au xénon, une diode laser ou un laser.

37. Dispositif selon l'une des revendications 27 à 36, **caractérisé en ce que** la tête de buse / tête d'impression (5, 51, 52) est disposée au niveau d'un premier galet de renvoi (3, 9) et la source de lumière (7) est disposée au niveau d'un deuxième galet de renvoi (4, 10) distant du premier galet de renvoi (3, 9).

38. Dispositif selon l'une des revendications 27 à 36, **caractérisé en ce que** la tête de buse / tête d'impression (5, 51, 52) et la source de lumière (7) sont disposées au niveau du même galet de renvoi (4).
